(19) Europäisches Patentamt
European Patent Office
Office européen des brevets

(11) **EP 2 256 506 B1**

(12) **EUROPÄISCHE PATENTSCHRIFT**

(45) Veröffentlichungstag und Bekanntmachung des Hinweises auf die Patenterteilung:
**03.07.2019 Patentblatt 2019/27**

(51) Int Cl.:
**G01R 27/18** *(2006.01)* **G01R 27/02** *(2006.01)*
**G01R 31/02** *(2006.01)*

(21) Anmeldenummer: **09161290.3**

(22) Anmeldetag: **27.05.2009**

(54) **Verfahren und Vorrichtung zur Isolationsüberwachung von ungeerdeten Gleich- und Wechselspannungsnetzen**

Method and device for insulation monitoring of unearthed direct voltage and alternating current networks

Procédé et dispositif de surveillance de l'isolation de réseaux à courant continu et à courant alternatif non mis à la terre

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(43) Veröffentlichungstag der Anmeldung:
**01.12.2010 Patentblatt 2010/48**

(73) Patentinhaber: **Bender GmbH & Co. KG**
**35305 Grünberg (DE)**

(72) Erfinder:
• **Schäfer, Oliver**
  **35305 Grünberg (DE)**
• **Schepp, Karl**
  **35447 Reiskirchen (DE)**

(74) Vertreter: **advotec.**
**Patent- und Rechtsanwälte**
**Georg-Schlosser-Straße 6**
**35390 Gießen (DE)**

(56) Entgegenhaltungen:
EP-A- 0 593 007 EP-A- 0 654 673
EP-A- 1 586 910 JP-A- 11 304 855
US-A- 4 528 497 US-A- 4 638 242

**Beschreibung**

Die Erfindung betrifft ein Verfahren zur Isolationsüberwachung eines ungeerdeten Gleich- und/oder Wechselspannungsnetzes nach der Lehre des Patentanspruchs 1.

Weiterhin betrifft die Erfindung eine Vorrichtung zur Durchführung des oben genannten Verfahrens nach Anspruch 29.

Aus dem Stand der Technik sind Verfahren zur Isolationsüberwachung von Gleich- und Wechselspannungsnetzen bekannt, bei denen in einem Messzeitraum eine Gleichspannung gegenüber der Masse angelegt wird und deren zeitlicher Verlauf bis zum Abklingen einer Ableitkapazität verfolgt wird, ab der ein Isolationswiderstand gegen Masse gemessen werden kann.

Diese gleichspannungsbasierten Messverfahren sind jedoch aufgrund der vorhandenen Netzableitkapazitäten sowie diverser Störungen in dem zu überwachenden Netz oft ungenau bzw. nicht anwendbar, so dass in bekannter Weise bereits vorgeschlagen wurde, mehrere Messintervalle hintereinander durchzuführen und die dabei entstehenden Messwerte arithmetisch zu mitteln oder auf sonstige Weise zu korrelieren, um einen verbesserten Aufschluss über den Isolationswiderstand gegenüber Masse zu ermitteln. Diesbezüglich wird auf die EP 0 654 673 B1, die EP 1 586 910 B1 und die DE 101 06 200 C1 Bezug genommen.

Nachteilig an den vorgenannten Messverfahren ist allerdings, dass mehrere Messzeiträume betrachtet werden müssen, um einen gültigen Messwert zu ermitteln. In einer Variante muss ein stabiler Messpuls mit Hochrechnung von Zwischenwerten auf den Endwert erzeugt, sowie ein Vergleich des hochgerechneten Endwerts mit den gemessenen Endwerten vorgenommen werden, wobei dieser Verfahrensablauf kompliziert und störanfällig ist. Sobald der Vergleich keine Gleichheit bzw. eine nicht zulässige Abweichung ergibt, muss die Messung solange wiederholt werden, bis gültige Messwerte vorliegen. Insbesondere in den Fällen stark schwankender Netzbelastungen oder niederfrequenter Störanteile im Netz, hohen induktiven oder kapazitiven Lasten, insbesondere in Netzen in denen eine Regelung der Spannung stattfindet, wird entweder die Messzeit in Abhängigkeit von der Frequenz und Amplitude der Störung verlängert oder es können keine gültigen Messwerte bei akzeptablen Messzeiten aufgefunden werden.

In jüngster Zeit nimmt die Zahl durch Umrichter gesteuerter Motorapplikationen, in denen Wechsel-, oder Drehstrom-Synchron- bzw. Asynchronmaschinen Verwendung finden, stark zu. In diesen Netzen ist aufgrund der niedrigen Schaltfrequenz sowie Stell- und Regelvorgängen des Umrichters mit niedrigen Störfrequenzen und Schwankungen in den Spannungs- und Stromwerten zu rechnen, so dass konventionelle gleichspannungsbasierte Messverfahren zur Bestimmung des Isolationsmesswertes praktisch kaum einsetzbar sind. Daher können solche Verfahren Isolationsfehler nur in Betriebszeiten mit stabiler Spannung, beispielsweise im Stillstand oder bei definierten Motorzuständen, aber keinesfalls im Falle dynamischer Lastregelung eingesetzt werden.

Auf der anderen Seite sind aus dem Stand der Technik auch Verfahren zur Messung der Impedanz zwischen Phase und Erde bekannt, bei denen eine sinusförmige Messspannung zwischen einem isolierten System und Masse aufgebracht wird, wobei die Frequenz des Messsignals in einem festen Verhältnis zur Frequenz der Netzspannung steht.

So geht beispielsweise aus der US 5,450,328 ein mikrocontrollerimplementiertes sequenzselektives Messverfahren hervor, bei dem die Messfrequenz und Phasenlage abgestimmt zur Netzfrequenz eine Netzableitimpedanz Z berechnet, aus der ein ohmscher und ein kapazitiver Anteil herausgerechnet werden kann. Diesbezüglich erzeugen zwei Messspannungsquellen zwei um 180° verschobene Messspannungen in die beiden Phasen eines Wechselspannungsnetzes, die in das Netz einkoppelt werden, wobei ein frequenzselektives Voltmeter Messspannungen und -ströme aus dem Netz auskoppelt. Dieses Verfahren hat jedoch den Nachteil, dass es einen erhöhten Messaufwand sowie eine komplizierte Signalerfassung erforderlich macht, wobei insbesondere bei hohen Ableitkapazitäten nur eine recht ungenaue Abschätzung des Ableitwiderstandes erreicht werden kann.

In der EP 0 593 007 A2 ist ein Verfahren zur Bestimmung der elektrischen Netzableitung von ungeerdeten elektrischen Netzen beschrieben, in denen zwei Messwechselspannungen bzw. Messwechselströme einer vorbestimmten Frequenz $\omega 1$ bzw. $\omega 2$ eingeprägt werden und der entstehende Spannungsabfall UA1, UA2 bzw. Stromabfall am Innenwiderstand Ri=RK+RM des Messgerätes gemessen wird, wodurch Rückschluss auf den ohmschen Widerstand RE bzw. die Ableitkapazität CE der Isolationsimpedanz Z gemessen werden kann.

Aus der EP 0 654 673 A1 ist ein Verfahren zur Isolationsüberwachung in ungeerdeten Gleich- und Wechselstromnetzen bekannt, bei dem unter Vermeidung von Messwertverfälschungen kürzere Messzeiten dadurch erzielt werden, dass die Einzelimpulse der getakteten Messwechselspannung in ihrer Länge adaptiv an die Netzverhältnisse angepasst werden.

Nachteilig an allen oben genannten Verfahren ist, dass insbesondere bei Netzen mit hohen dynamischen Lasten, insbesondere bei Umrichterschaltungen für den Motorbetrieb beim Einsatz in Hybridelektrofahrzeugen nur ungenaue Messergebnisse ermittelt bzw. keine Messungen zur Überwachung des Isolationswiderstandes gegenüber Masse durchgeführt werden können.

Somit ist es Aufgabe der Erfindung, ein Verfahren und eine Vorrichtung zur Überwachung der Isolation ungeerdeter Gleich- und Wechselspannungsnetze vorzuschlagen, bei denen der Isolationswiderstand im Betrieb wesentlich genauer permanent überwacht werden kann, so dass eine sichere Erfassung von Isolationsfehlern insbesondere in Elektrofahrzeugen ermöglicht wird, um Unterbrechungen oder Störungen des Netzes, eine Gefährdung der Nutzer durch Fehlfunktion, ein Entstehen gefährlicher Berührungsspannung, den Verlust von Energie, Brand oder Explosion durch Funkenbildung oder Korrosion durch Fehlerströme effizient vermieden werden können.

Diese Aufgabe wird durch ein Verfahren nach dem Anspruch 1 und einer Vorrichtung nach Anspruch 29 gelöst.

Vorteilhafte Weiterentwicklungen sind Gegenstand der Unteransprüche. Erfindungsgemäß umfasst das Verfahren zur Isolationsüberwachung eines ungeerdeten Gleich- oder Wechselspannungsnetzes die folgenden Schritte:

- Generierung einer einseitig mit einer Masse verbundenen Messgleichspannung $U_{mess}$ = für eine vorbestimmbare Messzeitspanne $t_{var}$;

    - Generierung und Überlagerung mindestens einer mit einer Masse verbundenen Messwechselspannung $U_{mess\sim}$ mit einer Messperiodendauer $t_{cons}$ über die Messgleichspannung $U_{mess}$= zur Bildung einer Gesamtmessspannung Umess;
    - Einspeisung der Gesamtmessspannung $U_{mess}$ in das zu überwachende Spannungsnetz;
    - Bestimmung eines Isolationswiderstands $R_=$ auf Basis der Messgleichspannung $U_{mess=}$ und einer Isolationsimpedanz $Z_\sim$ auf Basis der Messwechselspannung $U_{mess\sim}$.

Somit schlägt das erfindungsgemäße Verfahren die Generierung einer Gesamtmessspannung $U_{mess}$ vor, die sich aus einem Gleichspannungsanteil $U_{mess=}$ und einem Wechselspannungsanteil $U_{mess\sim}$ zusammensetzt. Nach Einspeisung dieser Gesamtmessspannung kann an einem Messwiderstand ein Gesamtmessstrom $I_{mess}$ gemessen werden, der wiederum in den von der Messgleichspannung $U_{mess=}$ und Messwechselspannung $U_{mess\sim}$ erzeugten Anteil zerlegt werden kann. Mittels der durch die Messgleichspannung und Messwechselspannung erzeugten Messwerte können dann unabhängig voneinander ein Isolationswiderstand $R_=$ auf Basis der Messgleichspannung $U_{mess=}$ und eine Isolationsimpedanz $Z_\sim$, die sich in der Regel aus einem Isolationswiderstand $R_\sim$ und einer Ableitkapazität $C_\sim$ zusammensetzt, bestimmt werden.

Gerade in Fahrzeugnetzen von Hybridfahrzeugen mit hohen dynamischen Lastwechseln wurde durch Versuche und Messungen festgestellt, dass Spannungsänderungen, die durch Lade- und Entladezyklen der Energiespeicher des Hybridelektrofahrzeugs auftreten, sich als gravierende Störungen in einer herkömmlichen Isolationsüberwachungseinrichtung niederschlagen. Bei bekannten Messverfahren wird eine Messung bzw. ein Messzyklus unterdrückt, falls die Spannungsänderungen bestimmte Amplituden und Frequenzen im Bereich der Grundmessfrequenzen überschreiten. Dies führt in vielen Fällen dazu, dass der Isolationswiderstand nur während ungefähr 20% der gesamten Betriebszeit des Spannungsnetzes bestimmt werden kann.

Aufgrund der Aufspaltung der Isolationsüberwachungsmessung in einen unabhängig durchführbaren Gleich- und mindestens einen Wechselspannungsmessungsanteil kann zumindest mittels des Wechselspannungsanteils eine schnelle und von dynamischen Lastwechseln unabhängige Messung des Isolationsverhaltens des Spannungsnetzes vorgenommen werden, so dass die Wahrscheinlichkeit einer aktiven Messung des Isolationswiderstands während des Fahrbetriebs wesentlich erhöht werden kann. Des Weiteren können mit diesem Verfahren auch die für den Personenschutz relevanten Ableitimpedanzen überwacht werden.

In einer vorteilhaften Weiterentwicklung dieses Verfahrens erfolgt die Bestimmung des Isolationswiderstandes $R_\sim$ und der Isolationsimpedanz $Z_\sim$ durch eine Messung des durch den Gesamtmessspannung $U_{mess}$ erzeugten Gesamtmessstroms $I_{mess}$. Dabei wird der Gesamtmessstrom $I_{mess}$ in einen Messgleichstrom $I_{mess=}$ und in einen Messwechselstrom $I_{mess\sim}$ aufgespalten und eine Bestimmung des Isolationswiderstandes $R_=$ auf Basis des Gleichstromanteils $I_{mess=}$ und der Isolationsimpedanz $Z_\sim$ auf Basis des Wechselstromanteils $I_{mess\sim}$ vorgenommen.

Mit anderen Worten wird der durch die Gesamtnetzspannung $U_{mess}$ erzeugte Gesamtmessstrom $I_{mess}$ mittels eines beliebigen Verfahrens in einen Gleichanteil $I_{mess\sim}$ und in einen Wechselanteil $I_{mess\sim}$ aufgespalten. Diese Aufspaltung kann beliebig erfolgen, besonders vorteilhaft sind Frequenzfilter für die Aufspaltung, wobei in einem ersten Filterschritt ein Tiefpass unerwünschte hochfrequente Anteile aus dem gemessenen Spannungs- bzw. Strommesssignal herausfiltert, um dann in einem weiteren Filterschritt mit Hilfe eines Tiefpasses den Messgleichstrom $I_{mess=}$ und mittels eines Bandpasses den Messwechselstrom $I_{mess\sim}$ auszufiltern.

Durch die Filterung liegen zwei Stromkomponenten vor, die auf die Wirkung der entsprechenden Messspannungskomponenten zurückgehen und mit deren Hilfe unabhängig voneinander der Isolationswiderstand $R_=$ bzw. $R_\sim$ sowie im Falle der Messwechselspannung auch eine Ableitkapazität $C_\sim$ bestimmt werden kann.

Somit ist es vorteilhaft auch möglich und wünschenswert, aus der Isolationsimpedanz $Z_\sim$ sowohl einen Isolationswiderstand $R_\sim$ als auch eine Ableitkapazität $C_\sim$ zu bestimmen.

Grundsätzlich sollten der auf der Messgleichspannung $U_{mess=}$ beruhende Isolationswiderstand $R_=$ und der auf der Messwechselspannung $U_{mess\sim}$ beruhende Isolationswiderstand $R_\sim$ identische Werte liefern. Jedoch kann es insbesondere bei Netzen mit hohen Störungen und beispielsweise hohen Ableitkapazitäten zu Unterschieden bei der Bestimmung des Isolationswiderstandes kommen. In diesem Fall ist es vorteilhaft möglich, im Falle einer Spannungsnetz-spezifischen kleinen Ableitkapazität $C_\sim$ den Isolationswiderstand $R_\sim$ als Isolationswiderstand des Spannungsnetzes auszugeben und im Falle einer großen Ableitkapazität $C_\sim$ den Isolationswiderstand $R_=$ als Isolationswiderstand auszugeben. Somit wird vorgegeben, dass bei kleiner Ableitkapazität $C_\sim$ der Isolationswiderstand $R_\sim$ aufgrund der Messwechselspannung $U_{\text{mess}\sim}$ genauer als der Isolationswiderstand $R_=$ aufgrund der Messgleichspannung bestimmt werden kann. Im Falle hoher Ableitkapazitäten $C_\sim$ wird angenommen, dass der Isolationswiderstand genauer mit Hilfe der Messgleichspannungskomponenten bestimmt werden kann. Dabei sei darauf hingewiesen, dass die Beurteilung einer "niedrigen" oder einer "hohen" Ableitkapazität eines Netzes ein erfahrungsbasiertes Spezifikum darstellt, wobei typische Kapazitätseinflüsse wie Leitungslängen, Spannungshöhen, Leiterquerschnitte, verwendete Isolationsmaterialien, Leitungsführung etc, d.h. netztopologische Einflüsse berücksichtigt werden.

Aufgrund der Eigenschaft des erfindungsgemäßen Verfahrens, Isolationswiderstände $R_\sim$ und $R_\sim$ auf unterschiedlichem Wege zu ermitteln, kann es durchaus sinnvoll sein, die auf verschiedenen Wegen ermittelten Isolationswiderstände miteinander zu vergleichen, um Aussagen über die Genauigkeit des Verfahrens treffen zu können.

So sollte in einem besonders ausgezeichneten Ausführungsbeispiel im Falle eines toleranzüberschreitenden Unterschieds zwischen den Isolationswiderständen $R_\sim$ und $R_=$ das Verfahren unter Veränderung der Gleichspannungsmesszeitspanne $t_{\text{var}}$ und/oder der Messperiodendauer $t_{\text{cons}}$ wiederholt werden, bis die Isolationswiderstände $R_=$ und $R_\sim$ sich zumindest innerhalb eines vorbestimmbaren Toleranzbereichs angenähert haben. So können verschiedene Messergebnisse der Isolationswiderstände ein Indikator für ungenaue Messungen sein, bei denen entweder der Gleichspannungsmesszeitraum $t_{\text{var}}$ oder die Frequenz der Messwechselspannung ($1/t_{\text{cons}}$) verändert werden sollte, um genauere Aussagen über den Isolationswiderstand zu erhalten. Durch die Definition eines Tolleranzintervalls, in denen sich die beiden Isolationswiderstände annähern, kann sichergestellt werden, dass eine gewisse vorgegebene Genauigkeit der Isolationswiderstandsbestimmung erreicht werden kann. Grundsätzlich kann die Bestimmung der Isolationswiderstände auf analogem Wege erfolgen. Jedoch ist es denkbar und überaus vorteilhaft, dass die Messung des Gesamtstroms $I_{\text{mess}}$ oder der Teilmessströme $I_{\text{mess}=}/I_{\text{mess}\sim}$ eine Digitalisierung der Messwerte umfasst. Mittels einer Digitalisierung können mit Hilfe signaltheoretischer Ansätze eine weitere Signalverarbeitung erleichtert durchgeführt werden, bei denen beispielsweise softwarebasierte Veränderungen des Messverfahrens einfach und unkompliziert vorgenommen werden können.

Wie bereits oben angedeutet ist nach einem ausgezeichneten Ausführungsbeispiel der Gesamtmessstrom $I_{\text{mess}}$ in die beiden Teilmessströme $I_{\text{mess}=}$ und $I_{\text{mess}\sim}$ aufzuspalten. Zur Extraktion des Messgleichstroms $I_{\text{mess}=}$ bietet sich vorteilhaft an, diesen mittels einer Tiefpassfilterung aus dem Gesamtmessstrom $I_{\text{mess}}$ abzuleiten. Des Weiteren bietet sich ebenfalls an, den Messwechselstrom $I_{\text{mess}\sim}$ aus dem Gesamtmessstrom $I_{\text{mess}}$ mittels einer Bandpassfilterung zu extrahieren. Dabei kann es besonders vorteilhaft sein, wenn die Bandbreite und die Bandmittelfrequenz des eingesetzten Bandpassfilters und/oder die Grenzfrequenz des Tiefpassfilters elektronisch einstellbar ist. Insbesondere im Fall einer digitalen Verarbeitung des Messstroms und/oder der Messspannungen kann somit softwaremäßig eine Einstellbarkeit der eingesetzten Filterkoeffizienten leicht vorgenommen werden.

Grundsätzlich kann der Isolationswiderstand beliebig oft zu verschiedenen Zeitpunkten bestimmt werden. Jedoch ist es besonders vorteilhaft, dass das Verfahren zur Isolationsüberwachung zyklisch, d.h. wiederholend und insbesondere kontinuierlich mit einstellbaren Messabstandszeiten durchgeführt wird. Eine zyklische Messung garantiert, dass im laufenden Betrieb ständig aktuelle Messergebnisse über den Isolationszustand des Netzes vorliegen. Eine kontinuierliche Isolationsüberwachung bedeutet dabei, dass in regelmäßigen Zeitabständen eine erneute Messung des Isolationszustandes vorgenommen wird.

Bereits aus dem Stand der Technik ist bekannt, dass bei der Ermittlung des Isolationswiderstandes $R_=$ Schwankungen, die durch dynamische Lastwechsel oder niederfrequente Anteile verursacht werden, gewisse Fehlerquellen darstellen. Somit kann in einem vorteilhaften Ausführungsbeispiel die Ermittlung des Isolationswiderstands $R_=$ und/oder $R_\sim$ mittels einer statistischen Auswertung der Messwerte mehrerer hintereinander durchgeführter Messzyklen mit Messzeitspannen $t_{\text{var}}$, insbesondere eine gleitende Mittelwertbildung vorgenommen werden. Somit lässt sich bei wiederholt vorgenommenen Messungen des Isolationszustands eine genauere Ermittlung des Isolationswiderstandes mittels beispielsweise gleitender Mittelwertbildung oder Approximation der letzten gemessenen Isolationswiderstände vornehmen, um eine genaue Ermittlung des Isolationswiderstandes zu erreichen und systembedingte Fehlerquellen zu unterdrücken.

Des Weiteren ist es durchaus vorstellbar, dass die Messzeitspanne $t_{\text{var}}$ variable für jeden Messzyklus einstellbar ist, um den Ableitkapazitäten und Störungen des Spannungsnetzes entgegenzuwirken. So kann beispielsweise bei hohen dynamischen Lastwechseln eine Verlängerung der Messzeitspanne $t_{\text{var}}$ vorgenommen werden, um eine erneute Messung in einem Zeitraum, in denen die Lastwechsel gering sind, vorzunehmen und somit eine hohe Messgenauigkeit zu erreichen.

Hierfür ist es insbesondere vorteilhaft, dass die Messzeitspanne $t_{\text{var}}$ variabel für jede Messzyklusspanne einstellbar ist, um die Ableitkapazität exakt zu bestimmen und Störungen des Spannungsnetzes entgegenzuwirken.

Grundsätzlich kann die Messzeitspanne für die Messung der Gleichspannungskomponente $R_=$ beliebig gewählt werden. Jedoch hängt die Genauigkeit der Messung der Gleichspannungsergebnisse grundsätzlich von der Höhe der Ableitkapazität $C_\sim$ ab, die ein Einschwingverhalten der Gleichspannungsmessung bewirkt. Daher ist es vorteilhaft, dass die Messzeitspanne $t_{var}$ nach einer ermittelten Isolationsimpedanz $Z_\sim$, die eine Aussage über die Ableitkapazität $C_\sim$ ermöglicht, nach der Formel $t_{var}=n*R_i*C_\sim$ mit $R_i$ als Innenwiderstand der Isolationsmessvorrichtung und $n\geq3$ bestimmt wird.

Besonders vorteilhaft sollte die Gleichspannungsmesszeitdauer $t_{var}$ mit $5*R_i*C_\sim$ bestimmt werden, um eine hohe Genauigkeit der Gleichspannungsmessergebnisse zu gewährleisten.

Dabei kann in typischen Anwendungsfällen die Messzeitspanne $t_{var}$ mindestens eine Sekunde betragen oder für eine Zeitdauer zwischen einer und fünf Sekunden gewählt werden.

Des Weiteren ist es vorteilhaft, dass die Messperiodendauer $t_{cons}$ ein ganzzahliger Bruchteil des Messzeitraumes $t_{var}$ ist, so dass eine ganzzahlige Anzahl von Messschwingungen des Frequenzmessanteils $U_\sim$ in einen Messzeitraum $t_{var}$ der Messgleichspannung $U_=$ aufgenommen werden kann.

Insbesondere ist es vorteilhaft, dass die Messperiodendauer $t_{cons}$ in etwa $t_{var}/10$ beträgt. Des Weiteren ist es vorteilhaft, dass die Messperiodendauer $t_{cons}$ in etwa 0,1 Sekunden beträgt.

Nach einem ausgezeichneten Ausführungsbeispiel hat sich ein mathematischer Zusammenhang zwischen Messperiodendauer $t_{cons}$, Größe der Ableitkapazität $C_\sim$ und dem Ansprechwert $R_a$ der Isolationsmesseinrichtung, d.h. der untersten Messschwelle der Messeinrichtung, ab der eine Isolationsfehlermeldung ausgegeben werden kann, herausgebildet, bei dem die Relation $t_{cons} < 2\pi C_\sim R_a$ eingehalten werden sollte. Somit ist eine Frequenz der Messwechselspannung vorgegeben, die sicherstellt, dass eine hohe Genauigkeit der Wechselspannungsmesswerte der Isolationskapazität und des Isolationswiderstandes erreichbar bleibt.

Grundsätzlich ist die Signalverarbeitung zur Ermittlung des Ableitwiderstandes und der Ableitkapazität beliebig auslegbar. Nach einem oben genannten besonderen Ausführungsbeispiel erfolgt die Signalverarbeitung digital, so dass es hierbei grundsätzlich vorteilhaft ist, die Isolationsimpedanz $Z_\sim$ mittels einer diskreten Fouriertransformation, ausgelegt als DFT/FFT, durchzuführen, wobei zumindest die Bestimmung der Isolationsimpedanz $Z_\sim$, der Ableitkapazität $C_\sim$ und des Isolationswiderstands $R_\sim$ im Frequenzbereich erfolgen kann. Durch eine Ermittlung des Isolationsverhaltens auf Basis der Wechselspannungskomponenten kann eine einfache Auswertung mit einstellbaren Filtereigenschaften und einer beliebigen Genauigkeit erreicht werden.

Grundsätzlich liefert das erfindungsgemäße Verfahren zwei Werte $R_=$ und $R_\sim$ für den Isolationswiderstand. Auf Basis der Messwechselspannung kann eine Gesamtimpedanz $Z_\sim$ ermittelt werden, die sich in der Regel aus einer Parallelschaltung eines Isolationswiderstands $R_\sim$ und einer Ableitkapazität $C_\sim$ ergibt. Gerade in Fällen, in denen der frequenzbasierte Isolationswiderstand $R_\sim$ nur ungenau bestimmt werden kann, ist es durchaus vorteilhaft und denkbar, falls die Ableitkapazität $C_\sim$ aus der Gesamtimpedanz $Z_\sim$ und dem in diesem Fall meist genauer bestimmbaren Isolationswiderstand $R_=$ berechnet wird. So ist es durchaus vorteilhaft, die Ableitkapazität $C_\sim$ nach der Formel einer Parallelschaltung und unter Berücksichtigung des Gleichspannungsisolationswertes $R_=$ mit

$$C_\sim = \frac{1}{\omega}\sqrt{\frac{1}{Z_\sim^2}-\frac{1}{R_=^2}}$$

zu bestimmen. Somit dient der in vielen Fällen genauer bestimmbare Gleichspannungsisolationsmesswert zur genaueren Bestimmung der Ableitkapazität $C_\sim$.

Grundsätzlich kann das erfindungsgemäße Verfahren für die Isolationsbestimmung beliebiger Gleich- und/oder Wechsel- oder Drehstromnetze herangezogen werden. Insbesondere eignet sich das Verfahren für eine Verwendung in einem Spannungsnetz mit dynamisch veränderbarer Spannung, bei dem eine Isolationsüberwachung in einer Umrichterschaltung zum dynamischen Betrieb eines Wechsel- oder Drehstrommotors eingesetzt wird, wobei ein Gleichstromkreis über einen Umrichter mit einem Motorstromkreis gekoppelt ist. Aufgrund der dynamischen Entwicklung in der Leistungshalbleitertechnologie ist es möglich, aus Gleichspannung eine beliebigfrequente Wechsel- oder Drehspannung bei hohen Leistungen zu erzeugen. Somit häufen sich Anwendungen, in denen Drehstrom-Synchronbzw. Asynchronmotoren mittels eines Umrichters und eines energieliefernden Gleichstromkreises betrieben werden, um unterschiedliche Drehzahlen und Leistungen zu erzeugen. Ein solcher Motorstromkreis ist durch den Umrichter in einen Gleichstrom- und einem Motorstromkreis zweigeteilt. Das Verfahren eignet sich besonders gut in Fällen dynamischen Lastwechsels der Motoransteuerung, in denen sowohl das Isolationsverhalten des Gleichstromkreises, als auch das Verhalten des Motorstromkreises unabhängig voneinander oder auch kombiniert miteinander gemessen werden können.

Insbesondere eignet sich das Verfahren in einem besonderen Ausführungsbeispiel bei Anwendung in einem Fahrzeug mit Elektromotorantrieb, insbesondere in einem Hybridkraftfahrzeug zur Isolationsüberwachung. Hybridkraftfahrzeuge zeichnen sich dadurch aus, dass sie sowohl einen herkömmlichen Verbrennungsmotor als auch einen Elektromotor aufweisen, bei dem der Verbrennungsmotor in Lehrlaufphasen eine Batterie speist und im Belastungsfalle der Elektroantrieb zugeschaltet oder gänzlich die Bewegung des Fahrzeugs übernimmt, wobei hohe dynamische Belastungen auftreten und eine Überwachung des Isolationswiderstands gegenüber Masse eine hohe Bedeutung zukommt, um Fehlverhalten, Kurzschlüsse oder Brände im Fahrzeug zu verhindern. In diesem Zusammenhang dient der Elektromotor häufig als Generator, der beispielsweise bei Bergabfahrten Strom zur Speicherung in den Fahrzeugbatterien erzeugt. Auch im Falle eines generatorischen Betrieb ist es daher vorteilhaft, dass das Isolationsverfahren eine Überwachung der Isolationsverhältnisse bei Energietransfer vom Motor/Generatorkreis zum Gleichstromkreis vornimmt.

Wie bereits oben angedeutet eignet sich das Verfahren ausgezeichnet zur Überwachung des Isolationswiderstandes und der Ableitimpedanz in einem Gleichspannungskreis aber auch in einem Motorstromkreis. Insbesondere eignet sich das Verfahren zur Verwendung der Bestimmung des Isolationswiderstands bzw. der Ableitimpedanz des Gleichstromkreises und/oder des Wechsel- oder des Drehstrommotorkreises, wobei eine kombinierte Überwachung beider Stromkreise besonders vorteilhaft erscheint. Im Falle einer Simultanüberwachung der Isolationswiderstände/Impedanz des Gleich- und Motorstromkreis ist es besonders vorteilhaft, die Messperiodendauern $t_{cons}$ der jeweiligen Messwechselspannungen $U_{mess\sim}$ so zu wählen, dass sich die Messsignale im Frequenzbereich nicht gegenseitig stören. In der Regel findet eine Messung der Isolationswiderstände bei abgeschaltetem Umrichter statt, so dass sich die Messungen der Isolationswiderstände in Gleichstrom und Motorstromkreis nicht gegenseitig beeinflussen können. Jedoch ist es denkbar und möglich, bei aktivem Umrichter eine kombinierte Messung von Gleichstrom- und Motorstromkreis durchzuführen, jedoch ist es in diesem Fall besonders vorteilhaft, wenn die Messfrequenzen $1/t_{cons}$ beider Stromkreise unterschiedlich gewählt werden, damit sich die Frequenzmessspannungen/-ströme nicht gegenseitig überlagern und stören. Jedoch ist es alternativ ebenfalls denkbar, die Messungen in beiden Stromkreisen im Zeitmultiplex in Zeiten durchzuführen, in denen im jeweils anderen Stromkreis keine Messung durchgeführt wird.

Des Weiteren könnte es durchaus denkbar sein, nur in einem einzigen Stromkreis zwei oder mehrere unterschiedliche Messfrequenzen einzusetzen, um mehrere im Frequenzbereich separierbare Ableitimpedanzen zu bestimmen, um aus diesen unabhängig voneinander das Isolationsverhalten des Spannungsnetzes zu bestimmen.

In der Regel genügt eine Ankopplung der Gesamtmessspannung $U_{mess}$ über einen einzigen Ankoppelwiderstand in das Spannungsnetz, da beispielsweise in einem Gleichspannungsnetz über eine niederohmige Gleichspannungsquelle alle stromführenden Leiter gegenüber Masse gemessen werden können, sowie im Wechselspannungsnetz im Motorstromkreis aufgrund der niederohmigen Motorwicklungen ebenfalls alle Motorphasen überwacht werden können. Im Rahmen einer Messung eines Gleichspannungsnetzes ist es dennoch sinnvoll, dass die Gesamtmessspannung $U_{mess}$ über zwei Ankoppelwiderstände in die beiden Gleichspannungspfade zwischen Gleichspannungsquelle und Umrichter eingekoppelt wird. Des Weiteren ist es durchaus sinnvoll, dass im Falle einer Messung des Motorspannungskreises die Gesamtmessspannung $U_{mess}$ über mindestens zwei Ankoppelwiderstände in mindestens zwei Phasen eines dreiphasigen Motorstromkreises eingekoppelt wird. Schließlich kann es bei einer kombinierten Messung des Gleichstromkreises und des Motorstromkreises durchaus denkbar und sinnvoll sein, über mindestens zwei Einkoppelwiderstände die Gesamtmessspannung einzukoppeln, wobei ein erster Ankoppelwiderstand in den Gleichstromkreis und ein zweiter Ankoppelwiderstand in den Motorstromkreis einkoppelt und wobei zumindest der Isolationswiderstand beider Stromkreise bestimmbar ist, wenn kein Energietransfer durch Umrichter erfolgt.

Eine weitere Ausführungsform des Verfahrens umfasst einen automatischen periodischen Selbsttest der die Isolationsüberwachung durchführende Vorrichtung. Hierzu wird in regelmäßigen Zeitabständen, beispielsweise alle 5 Minuten, alle isolationsüberwachenden Bauteile, insbesondere die Isolationsüberwachungsvorrichtung an sich sowie die darin befindlichen Bauteile auf Funktion getestet, und der korrekte Anschluss der Vorrichtung an das zu überwachende Netz, insbesondere der möglichst niederohmige Anschluss an die Masse des Netzes überprüft.

Des Weiteren betrifft die Erfindung eine Vorrichtung zur Durchführung eines oben genannten Verfahrens, wobei die Vorrichtung eine einseitig mit einer Masse verbundene Impulsmessspannungsquelle zur Generierung einer Gesamtmessspannung $U_{mess}$, mindestens ein Ankoppelnetzwerk umfassend mindestens einen Ankoppelwiderstand und einen Messwiderstand zum Einkoppeln der Gesamtmessspannung $U_{mess}$ in das Spannungsnetz und eine Isolationsmesseinrichtung zur Bestimmung der Ableitimpedanz.

Erfindungsgemäß ist die Vorrichtung dadurch gekennzeichnet, dass die Impulsmessspannungsquelle ausgelegt ist, eine Gesamtmessspannung $U_{mess}$ zu generieren, die sich aus einer Überlagerung einer Messgleichspannung $U_{mess=}$ mit einer vorbestimmbaren Messzeitspanne $t_{var}$ und mindestens einer Messwechselspannung $U_{mess\sim}$ mit einer Messperiodendauer $t_{cons}$ ergibt. Des Weiteren ist die Isolationsmesseinrichtung dazu ausgelegt, um auf Basis der Messgleichspannung $U_{mess=}$ einen Isolationswiderstand $R_=$ und auf Basis der Messwechselspannung $U_{mess\sim}$ eine Isolationsimpedanz $Z_\sim$ zu bestimmen.

Somit betrifft die erfindungsgemäße Vorrichtung eine grundsätzlich aus dem Stand der Technik bekannte Vorrichtung, die eine Impulsmessspannungsquelle zur Generierung einer Gesamtmessspannung $U_{mess}$, ein Ankoppelnetzwerk mit einem Ankoppelwiderstand, mit deren Hilfe die Gesamtmessspannung $U_{mess}$

in dem zu messenden Spannungsnetz angekoppelt werden kann und einen Messwiderstand, an dem eine Isolationsmesseinrichtung einen Spannungsabfall messen kann, um hieraus einen Gesamtmessstrom $I_{mess}$ zu bestimmen, umfasst. Die Impulsmessspannungsquelle ist so auszulegen, dass sie eine Superposition einer Messgleichspannung $U_{mess=}$ und einer Messwechselspannung $U_{mess\sim}$ generieren kann, wobei die Isolationsmesseinrichtung basierend auf dem Gleichspannungsanteil $U_{mess=}$ einen Isolationswiderstand $R_=$ und basierend auf dem Wechselspannungsanteil $U_{mess\sim}$ einen Impedanzwert $Z_\sim$ bestimmt.

Dabei ist es naheliegend und vorteilhaft, dass die Isolationsmesseinrichtung zur Aufspaltung der beiden Messkomponenten, die auf der Messgleichspannung $U_{mess=}$ und der Messwechselspannung $U_{mess\sim}$ basieren, Filterelemente umfasst, die ausgelegt sind, einen am Messwiderstand gemessenen Gesamtstrom $I_{mess}$ in einen Messgleichstrom $I_{mess=}$ und in einen Messwechselstrom $I_{mess\sim}$ aufzuspalten, wobei die Bestimmung des Isolationswiderstandes $R_=$ auf Basis des Messgleichstroms $I_{mess=}$ und der Isolationsimpedanz $Z_\sim$ auf Basis des Messwechselstroms $I_{mess\sim}$ erfolgt. Die Filterelemente dienen folglich dazu, die aus der Gesamtmessspannung $U_{mess}$ hervorgehenden Einzelmessspannungen und daraus resultierende Messströme aufzuteilen, um getrennt voneinander eine Gleichspannungs- und eine Wechselspannungsmessung des Isolationsverhaltens durchzuführen.

Dabei ist es vorteilhaft, dass die Filterelemente mindestens einen Tiefpass für eine Ermittlung des Isolationswiderstandes $R_=$ und einen Band-pass für die Ermittlung der Isolationsimpedanz $Z_\sim$ umfasst. Der Tiefpass dient dazu, die unterhalb der Messfrequenz befindlichen Signalanteile auszukoppeln, um diese als die zur Messgleichspannung $U_{mess=}$ gehörigen Werte zur Messung eines Isolationswiderstandes $R_=$ heranzuziehen. Der Bandpass dient dazu, diejenigen Frequenzanteile aus den gemessenen Werten herauszufiltern, die zu der Messwechselspannung $U_{mess\sim}$ gehören.

Des Weiteren ist es durchaus vorteilhaft, dass die Filterelemente einen vorgeschalteten Tiefpass zur Ausfilterung von Störsignalen umfassen. Der vorgeschaltete Tiefpass sollte möglichst alle Signalanteile, die über der Frequenz der Messwechselspannung $U_{mess\sim}$ liegen, ausfiltern, um hochfrequente Störeinflüsse auf die Messung zu unterdrücken.

Des Weiteren sind in einem besonderen Ausführungsbeispiel zumindest Teile der Filterelemente als im Betrieb elektronisch einstellbare Filterelemente ausgelegt, so dass Frequenzparameter wie Grenz-, Mitten- und Bandbreitenfrequenz einstellbar sind. So kann beispielsweise nach mehreren wiederholten Messzyklen, in denen nur ungenaue oder stark variierende Werte der Isolationswiderstände feststellbar sind, die Frequenz der Impulsmessspannung sowie die Filterfrequenzen derart verändert werden, dass die frequenzbasierten Messspannungswerte in einem anderen Frequenzbereich ermittelt werden können, in dem geringere Störungen auftreten.

Wie bereits oben erwähnt ist es besonders vorteilhaft, dass die Signalverarbeitung zur Ermittlung des Isolationszustandes digital erfolgt. Hierzu ist es vorteilhaft, wenn die Isolationsmesseinrichtung mindestens einen A/D-Wandler umfasst, um die im Messwiderstand gemessenen Strom- und/oder Spannungswerte digital zu wandeln. Des Weiteren ist es vorteilhaft denkbar, dass die Isolationsmesseinrichtung mindestens eine FFT/DFT-Verarbeitungseinrichtung umfasst, um zumindest die Messwerte zur Ermittlung der Ableitimpedanz $Z_\sim$ in den Frequenzbereich zu transformieren. Durch den Einsatz einer Frequenzbereichsanalyse können einfache Filter angewendet, bzw. genaue Impedanzwerte im Frequenzbereich ermittelt werden.

Schließlich ist es vorteilhaft, dass die Isolationsmesseinrichtung einen Mikrocontroller umfasst, der ausgelegt ist, eine Signalverarbeitung der gemessenen Spannungs- und Stromwerte vorzunehmen und den ermittelten Isolationswiderstand $R_=$ und die ermittelte Isolationsimpedanz $Z_\sim$ bzw. Isolationswiderstand $R_\sim$ und Ableitkapazität $C_\sim$ zu bestimmen. Mittels eines Mikrocontrollers können vorhandene Steuer- und Messsoftware ohne viel Mühe angepasst bzw. verändert werden, wodurch die Vorrichtung flexibel für neue Einsatzzwecke eingestellt werden kann.

Grundsätzlich übermittelt die Isolationsüberwachung Daten, vornehmlich digitale Daten an eine Betriebsstelle des Isolationsnetzes, so beispielsweise im Falle einer KFZ-Isolationsüberwachung an die Bordelektronik. Dies geschieht üblicherweise mittels eines I/O-Interfaces. Schließlich ist es vorteilhaft denkbar, falls die Isolationsmesseinrichtung ein I/O-Interface umfasst, wobei mittels eines Optokopplers PWM-modulierte Daten der Isolationsmesseinrichtung ausgegeben werden können, bzw. die Messeinrichtung zur Aktualisierung der Betriebssoftware oder zur Einstellung von Betriebsparametern programmiert werden kann. Mittels eines galvanisch getrennten I/O-Interfaces wird verhindert, dass im Falle von Störungen die Messelektronik in Leidenschaft gezogen wird oder Einflüsse des Versorgungsnetzes auf die Isolationsmesseinrichtung einwirken.

Im Rahmen der Datenübertragung ist es weiterhin denkbar und vorteilhaft, dass die Isolationsvorrichtung digitale Daten an ein standardisiertes Informationsübertragungs- oder Feldbussystem , insbesondere CAN-(Controller Area Network) oder LIN-Bus (Local Interface Network) übermitteln kann, so dass die Ein- und Ausgabedaten der Isolationsüberwachungsvorrichtung von einer übergeordneten Steuer- und Regelvorrichtung verarbeitet werden kann.

Im Folgenden stellen die Figuren vorteilhafte Ausführungsformen der oben genannten Erfindung dar.

Dabei zeigen:

**Fig. 1:** ein Schaltbild eines Ausführungsbeispiels einer erfindungsgemäßen Isolationsmessvorrichtung;

Fig. 2: den zeitlichen Verlauf einer Messgleichspannung $U_{\text{mess=}}$ eines Ausführungsbeispiels;

Fig. 3: den Spannungsverlauf einer Messwechselspannung $U_{\text{mess}\sim}$ eines Ausführungsbeispiels;

Fig. 4: den Spannungsverlauf einer Gesamtmessspannung $U_{\text{mess}}$ eines Ausführungsbeispiels;

Fig. 5: ein Ablaufdiagramm eines Ausführungsbeispiels des erfindungsgemäßen Verfahrens;

Fig. 6: ein Schaltbild einer Isolationsmessvorrichtung zur Isolationsüberwachung des Gleichstromkreises und Motorstromkreises nach einem Ausführungsbeispiel;

Fig. 7: ein Ausführungsbeispiel einer Isolationsmessvorrichtung zur kombinierten Überwachung des Gleichstrom- und Motorstromkreises.

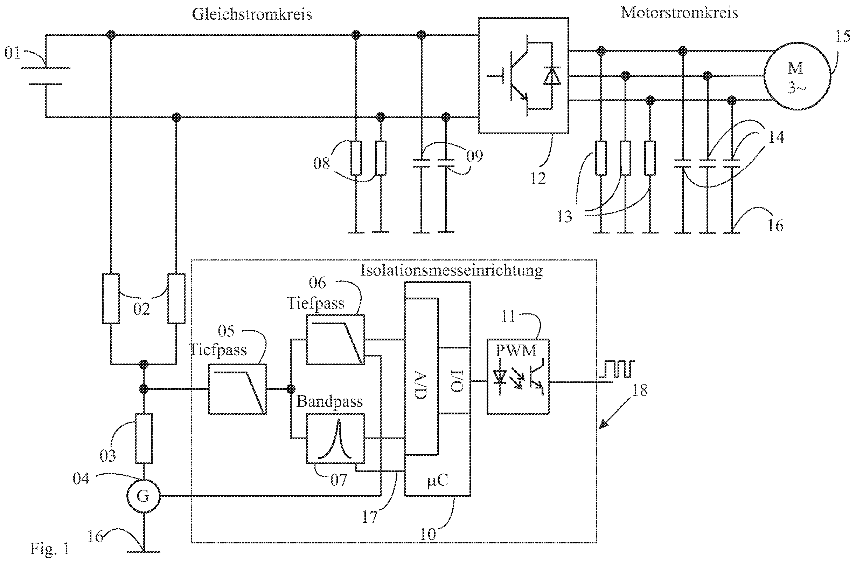

**Fig. 1** stellt ein Schaltbild eines Ausführungsbeispiels einer Isolationsmessvorrichtung dar. Dabei umfasst die Schaltung einen Gleichstromkreis, bei dem eine Batterie 01 einen Umrichter 12 speist, mit dessen Hilfe aus der Gleichspannung eine Drehspannung zum Betrieb eines Drehstrommotors 15 innerhalb eines Motorstromkreises umgerichtet wird. Der Gleichstromkreis weist einen Isolationswiderstand 08 und eine Ableitkapazität 09 gegenüber Masse auf. Des Weiteren weist der Motorstromkreis mit seinen dreiphasigen Zuleitungen zum Motor 15 drei Isolationswiderstände 13 sowie drei Ableitkapazitäten 14 zur Masse 16 auf. An den beiden Gleichspannungspotentialschienen, die die Batterie 01 mit dem Frequenzumrichter 12 verbinden, sind zwei Ankoppelwiderstände 02 eines Ankoppelnetzwerks einer Isolationsmesseinrichtung 18 angeschlossen.

Eine Impulsmessspannungsquelle 04 erzeugt eine Gesamtmessspannung $U_{\text{mess}}$. die sich aus einem Gleichanteil $U_{\text{mess=}}$ und einem frequenzbehafteten Anteil $U_{\text{mess}\sim}$ zusammensetzt, wobei die Impulsmessspannungsquelle 04 mit ihrem ersten Potential an der Masse 16 und mit ihrem zweiten Potential an einem Messwiderstand 03, dessen Größe genau bekannt ist, angeschlossen ist. Die von der Impulsmessspannungsquelle 04 erzeugte Gesamtmessspannung $U_{\text{mess}}$ fließt über den Messwiderstand 03, die beiden Ankoppelwiderstände 02 und die Gleichspannungsstromschienen des Gleichstromkreises über Ableitkapazität 09 und Isolationswiderstand 08 zur Masse. Dabei fällt am Messwiderstand 03 eine Spannung ab, aus der auf die Größe des Gesamtmessstroms $I_{\text{mess}}$ geschlossen werden kann. Daher ist am Messwiderstand 03 die Isolationsmesseinrichtung 18 angeschlossen, wobei der Spannungsabfall zunächst über einen Tiefpass 05 gefiltert wird, um störende hochfrequente Anteile aus dem Messsignal zu entfernen. Danach wird die am Messwiderstand 03 abfallende Messspannung zum einen über einen Tiefpass 06 gefiltert, um den Gleichspannungsanteil $U_{\text{mess=}}$ herauszufiltern sowie über einen Bandpass gefiltert, um den der Frequenz der Messwechselspannung $U_{\text{mess}\sim}$ angepassten Frequenzbereich auszufiltern, um Strommesswerte für die Impedanzbestimmung zur Verfügung zu stellen. Der somit aufgespaltene Messstrom $I_{\text{mess=}}$ und $I_{\text{mess}\sim}$ wird einem Mikrocontroller 10 zugeführt, der eine Analog-Digital-Wandlung vornimmt, sowie ein Verfahren zur Bestimmung des Isolationswiderstandes $R_=$ sowie der Ableitimpedanz $Z_\sim$, aus der Isolationswiderstand $R_\sim$ sowie Ableitkapazität $C_\sim$ ableitbar ist, durchführt. Das Ergebnis der Isolationsmessung wird vom Mikrocontroller 10 über einen Optokoppler 11 an einer Überwachungseinrichtung (nicht dargestellt) weitergegeben.

Grundsätzlich wird somit über eine konstante Impulsmessspannung eine periodische Pulsmessspannung überlagert und durch eine getrennte Filterung der beiden Messspannungsanteile mittels des Tiefpassfilters 06 und des Bandpassfilters 07 der Isolationswiderstand mit zwei verschiedenen Methoden bestimmt. Aus dem Messsignal des Eingangstiefpasses 05 werden zwei Messendwerte ermittelt und miteinander verglichen, wobei bei Übereinstimmung ein Isolationswert aus den beiden Spannungswerten berechnet wird. Eine Übereinstimmung der beiden Isolationswerte $R_\sim$ und $R_=$ zeigt, dass der Wert für den Gleichspannungsmesswert $R_=$ eingeschwungen ist. Mit dem Messsignal des Bandpasses wird im Mikrocontroller 10 eine diskrete Fouriertransformation durchgeführt, um daraus eine Impedanz $Z_\sim$ zu ermitteln, aus der wiederum der Isolationswiderstand $R_\sim$ sowie die Ableitkapazität $C_\sim$ der Messwechselspannung berechnet werden können. Durch den steilflankigen Bandpass werden dynamische Spannungsänderungen ausgefiltert und es ist eine kontinuierliche Messung des Isolationswiderstands bei kleinen Netzableitkapazitäten möglich. Bei größeren Netzableitkapazitäten wird der Isolationsmesswert aus den Gleichspannungs-Endwerten eines Messzyklus berechnet. Durch dynamische Spannungsschwankungen ergeben sich unterschiedliche Endwerte und die Messwertausgabe kann unterdrückt werden.

Um trotzdem eine kontinuierliche Messwertausgabe zu ermöglichen, wird ein statistisches Verfahren vorgeschlagen, beispielsweise eine gleitende Mittelwertbildung, die dazu dient, die Messwertschwankungen zu unterdrücken und eine kontinuierliche Messwertausgabe zu sichern.

Zur Vermeidung von Messfehlern durch Störungen im Bereich der Impulsmessspannungsfrequenz wird weiterhin vorgeschlagen, die Bandmittelfrequenz des Bandpasses, die Grenzfrequenz des Tiefpasses sowie die Frequenzen der Impulsmessspannung einstellbar auszuführen. Hierzu sind der Mikrocontroller 10, der Tiefpass 06, der Bandpass 07 sowie die Messspannungsquelle 04 miteinander verbunden, wobei der Mikrocontroller 10 die Frequenzdaten dieser Komponenten einstellen kann. Befinden sich beispielsweise größere Störspannungsamplituden im Bereich der Messfrequenz, kann durch ein Verschieben der Messfrequenz die Messqualität erhöht werden. Die Einstellung wird automatisch durch den Mikrocontroller 10 vorgenommen.

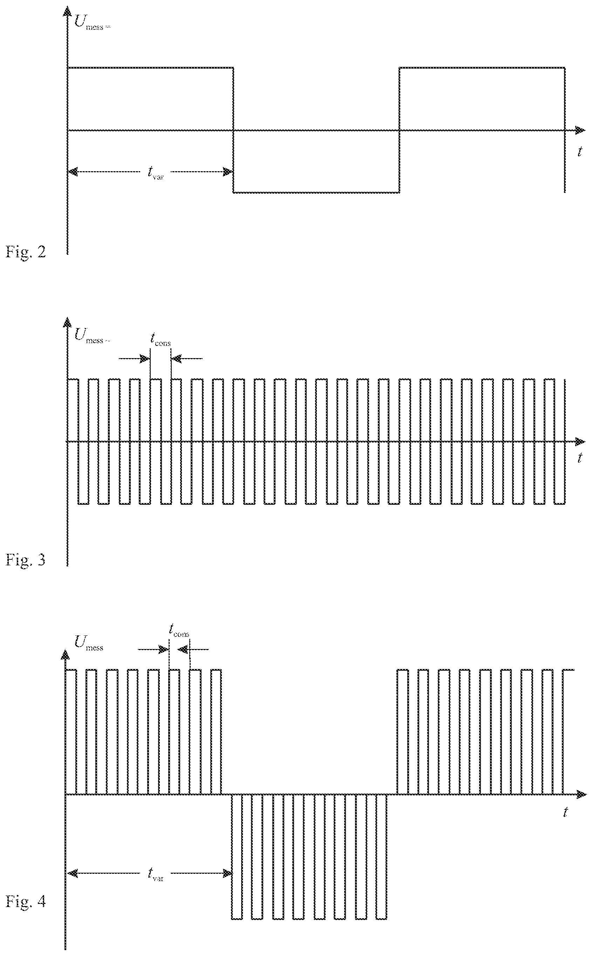

**Fig. 2** zeigt den grundsätzlichen Verlauf der Messgleichspannung $U_{mess=}$. Hierzu wird die Messgleichspannung $U_{mess=}$ über einen relativ langen Messzeitraum $t_{var}$ konstant gehalten, in dem der Messgleichstrom $I_{mess=}$ gemessen werden kann, um daraus den Isolationswiderstand $R_=$ zu bestimmen. Nach Ende des Messzeitraums $t_{var}$ kann, um systembedingte Fehler zu unterdrücken, eine anschließende kontinuierliche Messung mit umgekehrter Polarität fortgesetzt werden, so dass dauerhaft eine Messgleichspannung $U_{mess=}$ mit wechselnder Polarität anliegt. Somit weist selbst die Messgleichspannung $U_{mess=}$ eine extrem niederfrequente Amplitude auf, wobei jedoch innerhalb eines Messzeitraums $t_{var}$ eine Gleichspannungsmessung durchgeführt wird.

**Fig. 3** zeigt den zeitlichen Verlauf der Messwechselspannung $U_{mess\sim}$, die eine Periodendauer $t_{cons}$ aufweist. Dabei ist es vorteilhaft, wenn die Periodendauer $t_{cons}$ so gewählt wird, dass ein ganzzahliges Vielfaches von Impulsperioden der Messwechselspannung $U_{mess\sim}$ in einen Messzeitraum $t_{var}$ der Messgleichspannung $U_{mess=}$ passen.

Die durch die Superposition der in **Fig. 2** und **Fig. 3** dargestellten $U_{mess=}$ und $U_{mess\sim}$ sich ergebende Gesamtmessspannung $U_{mess}$ ist in **Fig. 4** dargestellt. Dabei überlagert die Messgleichspannung $U_{mess=}$ die Messwechselspannung $U_{mess\sim}$, wobei die Amplituden der Messgleichspannung $U_{mess=}$ exakt der Amplitude der Messwechselspannung $U_{mess\sim}$ entspricht, so dass innerhalb eines Gleichspannungsmesszeitraums $t_{var}$ nur positive Amplituden und in einem nachfolgenden Gleichspannungsmesszeitraum $t_{var}$ nur negative Amplituden der Gesamtmessspannung $U_{mess}$ auftreten.

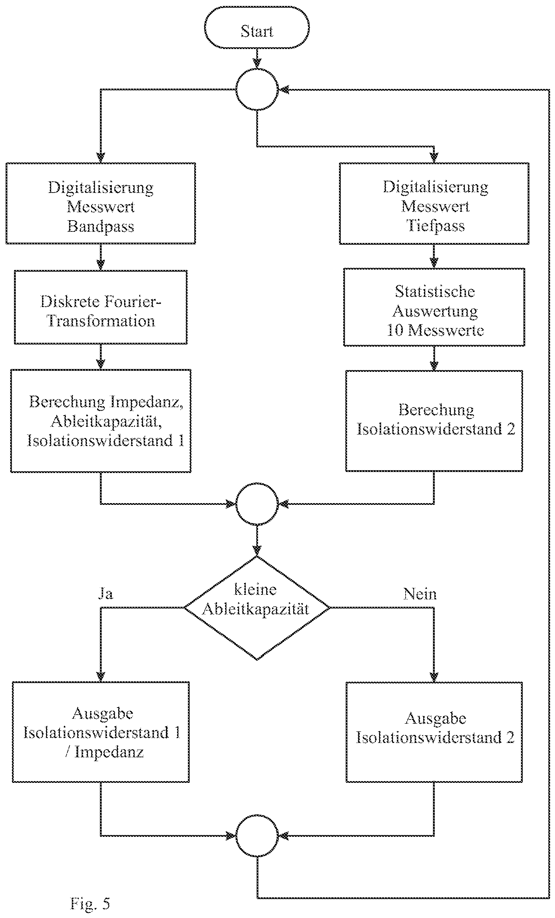

**Fig. 5** zeigt ein Ablaufdiagramm eines Ausführungsbeispiels des erfindungsgemäßen Verfahrens. Zunächst wird eine Bandpassfilterung sowie eine Tiefpassfilterung der Messströme durchgeführt und anschließend eine Digitalisierung, so dass digitale gemessene Stromkomponenten $I_{mess=}$ bzw. $I_{mess\sim}$ vorliegen. Die Wechselstromkomponente $I_{mess\sim}$ wird mittels einer diskreten Fouriertransformation in den Frequenzbereich transformiert, wobei im Frequenzbereich die Impedanz $Z_\sim$, die Ableitkapazität $C_\sim$ sowie der Isolationswiderstand $R_\sim$ (Isolationswiderstand 1) bestimmbar ist. Der digitalisierte Strommesswert $I_{mess=}$ wird statistisch über beispielsweise zehn vorangegangene Messwerte mittels eines Verfahrens des gleitenden Durchschnitts ausgewertet, um Messungenauigkeiten auszumitteln. Hieraus wird dann der Isolationswiderstand $R_=$ (Isolationswiderstand 2) bestimmt. Anschließend erfolgt ein Vergleich der beiden Isolationswiderstände. Ergibt die Berechnung der Ableitkapazität $C_\sim$ das Vorhandensein einer kleinen Ableitkapazität, bzw. weisen systembedingte Unterschiede zwischen Isolationswiderstand $R_=$ und $R_\sim$ auf eine kleine Ableitkapazität, so wird als Isolationswiderstand des zu überwachenden Netzes der Wechselspannungsisolationswiderstand $R_\sim$ (Isolationswiderstand 1) sowie die Impedanz $Z_\sim$ ausgegeben.

Ergibt die Bestimmung der Ableitkapazität $C_\sim$, dass eine hohe Ableitkapazität $C_\sim$ vorliegt - wobei der Begriff "hohe" sich auf eine netzspezifische Ableitkapazität, wie sie üblicherweise in solchen Netzen vorhanden ist, bezieht - so wird der gleichspannungsbasierte Isolationswiderstand $R_=$ ausgegeben. Anschließend beginnt das Verfahren von neuem zyklisch, vorteilhafterweise kontinuierlich eine durchgängige Überwachung des Isolationszustands des Netzwerks durchzuführen.

Somit wird bei kleinen Netzableitkapazitäten für die Ausgabe des Isolationsmesswertes der Realteil aus der diskreten Fouriertransformation verwendet. Je nach Applikation kann auch der Impedanzwert als Messwert ausgegeben werden. Bei größeren Ableitkapazitäten wird der Isolationsmesswert aus der proportionalen Spannung des Endwerts eines Messzyklus berechnet, dass heißt, es wird der Isolationsmesswert $R_=$ ausgegeben.

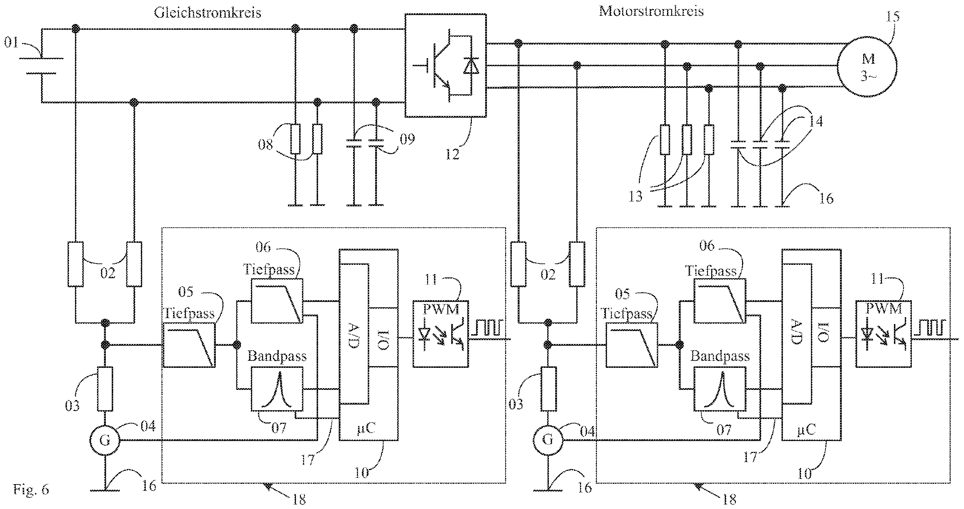

**Fig. 6** zeigt in einer Motorumrichterschaltung die kontinuierliche Überwachung sowohl des Gleichstromkreises mittels einer eigenen Isolationsmesseinrichtung 18 als auch des Motorstromkreises mit einer eigenen separaten Isolationsmesseinrichtung 18. Hierzu ist sowohl am Gleichstromkreis als auch am Motorstromkreis eine bereits in **Fig. 1** dargestellte Isolationsmesseinrichtung 18 mit Ankoppelnetzwerk angeschlossen. Wird die in **Fig. 1** dargestellte Isolationsmesseinrichtung 18 verwendet, so kann, sofern kein Energietransfer durch den Frequenzumrichter stattfindet, kein Isolationsfehler auf der Motorseite, d.h. im Motorstromkreis erfasst werden. Daher zeigt die in **Fig. 6** dargestellte Schaltung eine zweite Messeinrichtung 18 auf der Motorseite, die unabhängig von der Isolationsmesseinrichtung 18 des Gleichstromkreises arbeitet und die die Isolationsimpedanz bzw. den Isolationswiderstand des Motorstromkreises kontinuierlich überwacht.

Um eine gegenseitige Beeinflussung der beiden Messeinrichtungen 18 zu verhindern, werden für die Pulsmessspannungen, die durch die Impulsmessspannungsquellen 04 erzeugt werden verschiedene Frequenzen verwendet, die einen genügend hohen Störabstand zueinander aufweisen. Die Messfrequenz der ersten Einrichtung wird von der zweiten Einrichtung als Störfrequenz herausgefiltert und dadurch ergibt sich keine Beeinflussung der Messwerterfassung der beiden Isolationsmesseinrichtungen.

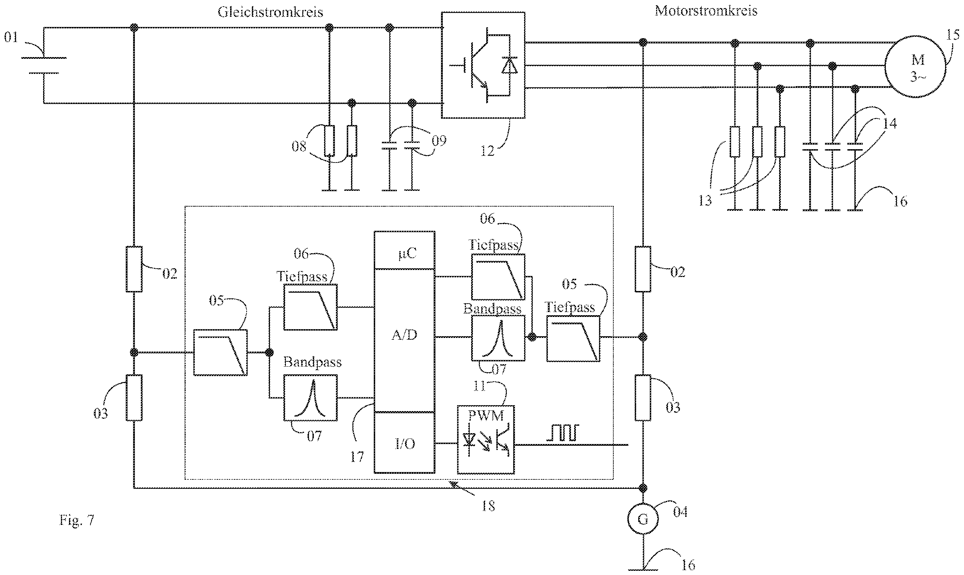

Schließlich zeigt **Fig. 7** eine Messeinrichtung 18, die eine kombinierte Überwachung sowohl der Isolationsverhältnisse des Gleichstrom- als auch des Motorstromkreises durchführen kann. Hierzu umfasst die Isolationsmesseinrichtung 18 ein Ankoppelnetzwerk, das aus einem Messwiderstand 03 sowie einem Ankoppelwiderstand 02 des Gleichstromkreises und einem Messwiderstand 03 und einem Ankoppelwiderstand 02 des Motorstromkreises besteht. Eine einzelne Impulsmessspannungsquelle 04, die mit der Masse des Versorgungsnetzes verbunden ist, erzeugt eine gemeinsame Gesamtmessspannung $U_{mess}$, die durch das Ankoppelnetzwerk sowohl dem Gleichstromkreis als auch dem Motorstromkreis zugeführt wird. Die Isolationsmesseinrichtung 18 umfasst hierzu zwei getrennte Filterkaskaden, jeweils bestehend aus einem vorgeschalteten Tiefpass 05, einem Tiefpass 06 zur Bestimmung des Gleichspannungsmessstroms $I_{mess=}$ sowie einem Bandpass 07 zur Bestimmung eines Wechselspannungsmessstroms $I_{mess\sim}$, die anschließend analog digital gewandelt werden und mittels eines Mikrocontrollers 10 zur Bestimmung der Ableitkapazität 09 und des Ableitwiderstands 08 des Gleichstromkreises sowie simultan des Ableitwiderstands 13 und der Ableitkapazität 14 des Motorstromkreises dient. Durch eine diskrete Fouriertransformation wird der Impedanzwert sowie der Isolationsmesswert und die Ableitkapazität sowohl im Gleich- als auch im Motorstromkreis bestimmt.

In der Regel wird der Impedanzwert sehr genau erfasst, während z. B. die Ableitkapazität durch Störungen im überwachenden Netz mit einer geringeren Genauigkeit berechnet werden kann bzw. fehlerhaft sein kann. Durch die redundante Berechnung des Isolationswiderstands mittels des Impulsspannungsverfahrens, lässt sich mit Hilfe des Impedanzwerts die Ableitkapazität auf einem zweiten Weg unabhängig bestimmen. Durch einen Vergleich der beiden Messwerte lässt sich die Qualität der Ableitkapazitätsmessung bewerten. Weiterhin ist es vorteilhaft, die beiden unterschiedlich ermittelten Isolationsmesswerte $R_=$ und $R_\sim$ miteinander zu vergleichen und bei einer bestimmten prozentualen Abweichung der Messwerte als ungültig zu bezeichnen, bzw. ab einer bestimmten Anzahl von ungültigen Messwertvergleichen ein Fehlersignal auszugeben.

Die in **Fig. 7** dargestellte Isolationsmessvorrichtung kann dazu dienen, Isolationsfehler auf der Motorseite zu bestimmen, selbst wenn kein Energietransfer durch den Frequenzumrichter erfolgt. Hierbei hat sie gegenüber der in **Fig. 6** dargestellten Vorrichtung den Vorteil, nur eine einzige Impulsmessspannungsquelle 04 sowie reduzierte Hardware innerhalb der Isolationsmesseinrichtung 18 zu benötigen. Es wird daher nur ein Mikrocontroller 10 und eine Messspannungsquelle 04 benötigt. Die Messspannungsquelle 04 erzeugt ein Signal mit zwei überlagerten Frequenzen, auf die jeweils die Bandpassfilter 07 des Gleichstromkreises und Motorstromkreises abgestimmt sind. Ein weiterer Vorteil gegenüber der in **Fig. 6** dargestellten Schaltung besteht darin, dass das Impulsmessverfahren störungsfrei und ohne Gefahr gegenseitiger Beeinflussung verwendet werden kann, weil nur eine Impulsmessspannungsquelle vorhanden ist und keine Beeinflussung durch eine zweite Quelle befürchtet werden muss.

**Patentansprüche**

1. Verfahren zur Isolationsüberwachung eines ungeerdeten Gleich- und/oder Wechselspannungsnetzes, umfassend die Schritte:

   - Generierung einer einseitig mit einer Masse (16) verbundenen Messgleichspannung $U_{mess=}$ für eine vorbestimmbare Messzeitspanne $t_{var}$;
   - Generierung und Überlagerung mindestens einer mit einer Masse (16) verbundenen Messwechselspannung $U_{mess\sim}$ mit einer Messperiodendauer $t_{cons}$ über die Messgleichspannung $U_{mess=}$ zur Bildung einer Gesamtmessspannung $U_{mess}$;
   - Einspeisung der Gesamtmessspannung $U_{mess}$ in das zu überwachende Spannungsnetz und Messung eines durch die Gesamtmessspannung $U_{mess}$ erzeugten Gesamtmessstroms $I_{mess}$, wobei der Gesamtmessstrom $I_{mess}$ in einen Messgleichstrom $I_{mess=}$ und einen Messwechselstrom $I_{mess\sim}$ aufgespalten wird;
   - Bestimmung eines Isolationswiderstands $R_=$ auf Basis der Messgleichspannung $U_{mess=}$ und des Messgleichstroms $I_{mess=}$, sowie der Isolationsimpedanz $Z_\sim$ auf Basis der Messwechselspannung $U_{mess\sim}$ und des Messwechselstroms $I_{mess}$.

2. Verfahren nach Anspruch 1,
   **dadurch gekennzeichnet,**
   **dass** aus der Isolationsimpedanz $Z_\sim$ ein Isolationswiderstand $R_\sim$ und eine Ableitkapazität $C_\sim$ bestimmt wird.

3. Verfahren nach Anspruch 2,
   **dadurch gekennzeichnet,**
   **dass** im Falle einer Spannungsnetz-spezifischen kleinen Ableitkapazität $C_\sim$ der Isolationswiderstand $R_\sim$ als Isolationswiderstand des Spannungsnetzes ausgegeben wird und im Falle einer großen Ableitkapazität $C_\sim$ der Isolationswiderstand $R_=$ als Isolationswiderstand des Spannungsnetzes ausgegeben wird.

4. Verfahren nach Anspruch 2 oder 3,
   **dadurch gekennzeichnet,**
   **dass** im Falle eines toleranzüberschreitenden Unterschieds zwischen den Isolationswiderständen $R_\sim$ und $R_=$ das Verfahren unter Veränderung der Gleichspannungsmesszeitspanne $t_{var}$ und/oder der Messperiodendauer $t_{cons}$ wiederholt wird, bis $R_\sim$ und $R_=$ sich zumindest innerhalb eines vorbestimmbaren Toleranzbereichs angenähert haben.

5. Verfahren nach einem der vorangegangenen Ansprüche,
   **dadurch gekennzeichnet,**

dass die Messung des Gesamtmessstroms $I_{mess}$ oder der Teilmessströme $I_{mess\sim}$ / $I_{mess=}$ eine Digitalisierung der Messwerte umfasst.

6. Verfahren nach einem der vorangegangenen Ansprüche,
   **dadurch gekennzeichnet,**
   **dass** die Aufspaltung des Gesamtmessstroms $I_{mess}$ in den Messgleichstrom $I_{mess=}$ zumindest eine Tiefpassfilterung des Gesamtmessstroms $I_{mess}$ mittels eines Tiefpasses (05, 06) umfasst.

7. Verfahren nach einem der vorangegangenen Ansprüche,
   **dadurch gekennzeichnet,**
   **dass** die Aufspaltung des Gesamtmessstroms $I_{mess}$ in den Messwechselstrom $I_{mess\sim}$ eine Bandpassfilterung des Gesamtmessstroms $I_{mess}$ mittels eines Bandpasses (07) umfasst.

8. Verfahren nach Anspruch 6 oder 7,
   **dadurch gekennzeichnet,**
   **dass** Bandbreite und Bandmittenfrequenz des Bandpassfilters (07) und/oder Grenzfrequenz des Tiefpassfilters (05, 06) elektronisch einstellbar ist.

9. Verfahren nach einem der vorangegangenen Ansprüche,
   **dadurch gekennzeichnet,**
   **dass** das Verfahren zur Isolationsüberwachung zyklisch, insbesondere kontinuierlich mit einstellbaren Messabstandszeiten durchgeführt wird.

10. Verfahren nach Anspruch 9,
    **dadurch gekennzeichnet,**
    **dass** die Bestimmung des Isolationswiderstands $R_=$ eine statistische Auswertung der Messwerte $R_=$, $I_{mess=}$ und/oder $U_{mess=}$ mehrerer hintereinander durchgeführter Messzyklen mit Messzeitspannen $t_{var}$, insbesondere eine gleitende Mittelwertbildung umfasst.

11. Verfahren nach Anspruch 9 oder 10,
    **dadurch gekennzeichnet,**
    **dass** die Messzeitspanne $t_{var}$ variabel für jeden Messzyklus einstellbar ist, um der Ableitkapazität und Störungen des Spannungsnetzes entgegenzuwirken.

12. Verfahren nach einem der vorangegangen Ansprüche,
    **dadurch gekennzeichnet,**
    **dass** eine Messzeitspanne $t_{var}$ nach ermittelter Isolationsimpedanz $Z_\sim$ nach der Formel $t_{var}=n*R_i*C_\sim$ mit R; als Innenwiderstand der Isolationsmessvorrichtung und $n \geq 3$ bestimmt wird.

13. Verfahren nach einem der vorangegangen Ansprüche,
    **dadurch gekennzeichnet,**
    **dass** die Messzeitspanne $t_{var}$ mindestens eine Sekunde beträgt.

14. Verfahren nach einem der vorangegangen Ansprüche,
    **dadurch gekennzeichnet,**
    **dass** die Messzeitspanne $t_{var}$ zwischen einer bis fünf Sekunden lang ist.

15. Verfahren nach einem der vorangegangen Ansprüche,
    **dadurch gekennzeichnet,**
    **dass** der Messzeitraums $t_{var}$ ein ganzzahliges Vielfaches der Messperiodendauer $t_{cons}$ ist.

16. Verfahren nach einem Anspruch 15,
    **dadurch gekennzeichnet,**
    **dass** die Messperiodendauer $t_{cons}$ in etwa $t_{var}/10$ beträgt.

17. Verfahren nach einem der vorangegangen Ansprüche,
    **dadurch gekennzeichnet,**
    **dass** die Messperiodendauer $t_{cons}$ in etwa 0.1 sek. beträgt.

18. Verfahren nach einem der vorangegangen Ansprüche,
    **dadurch gekennzeichnet,**
    **dass** die Messperiodendauer $t_{cons} < 2\pi C_\sim R_a$ ist, wobei $R_a$ der Ansprechwert einer Isolationsmesseinrichtung (18) ist, die die Isolationswerte misst.

19. Verfahren nach Anspruch 5,
    **dadurch gekennzeichnet,**
    **dass** die Bestimmung der Isolationsimpedanz $Z_\sim$ eine diskrete Fouriertransformation (DFT/FFT) umfasst, wobei zumindest die Bestimmung der Isolationsimpedanz $Z_\sim$, der Ableitkapazität $C_\sim$ und des Isolationswiderstands $R_\sim$ im Frequenzbereich erfolgt.

20. Verfahren nach einem der vorangegangenen Ansprüche ,
    **dadurch gekennzeichnet,**
    **dass** die Ableitkapazität $C_\sim$ mittels der gemessenen Isolationsimpedanz $Z_\sim$ und dem Isolationswider-

    stand $R_=$ nach $$C_\sim = \frac{1}{\omega}\sqrt{\frac{1}{Z_\sim^2} - \frac{1}{R_=^2}}$$ bestimmt wird.

21. Verwendung eines Verfahrens nach einem der vorangegangenen Ansprüche in einem Spannungsnetz mit dynamisch veränderbarer Spannung,

**dadurch gekennzeichnet,**
**dass** das Verfahren zur Isolationsüberwachung in einer Umrichterschaltung zum dynamischen Betrieb eines Wechsel- oder Drehstrommotors (15) eingesetzt wird, wobei ein Gleichstromkreis über einen Umrichter (12) mit einem Motorstromkreis gekoppelt ist.

22. Verwendung nach Anspruch 21,
**dadurch gekennzeichnet,**
**dass** das Verfahren in einem Fahrzeug mit Elektromotorantrieb, insbesondere in einem Hybrid-Kraftfahrzeug zur Isolationsüberwachung verwendet wird.

23. Verwendung nach Anspruch 22,
**dadurch gekennzeichnet,**
**dass** der Elektromotor auch als Generator arbeiten kann und ein Energietransfer von der Motorseite zur Gleichstromseite stattfinden kann, wobei das Verfahren die Isolation sowohl im motorischen als auch generatorischen Betrieb vorn überwachen kann.

24. Verwendung nach einem der Ansprüche 21 bis 23,
**dadurch gekennzeichnet,**
**dass** der Isolationswiderstand, bzw. die Ableitimpedanz des Gleichspannungskreises (08, 09) und/oder des Wechsel- oder des Drehstrom-Motorstromkreises (13, 14) überwacht wird.

25. Verwendung nach einem der Ansprüche 21 bis 24,
**dadurch gekennzeichnet,**
**dass** bei simultaner Überwachung der Isolationswiderstände/Impedanzen (08, 09, 13, 14) im Gleich- und Motorstromkreis die Messperiodendauern $t_{cons}$ der jeweiligen Messwechselspannungen Umess- so gewählt sind, dass sich die Messsignale nicht gegenseitig stören.

26. Verwendung nach einem der Ansprüche 21 bis 25,
**dadurch gekennzeichnet,**
**dass** die Gesamtmessspannung $U_{mess}$ über zwei Ankoppelwiderstände (02) in die beiden Gleichspannungspfade zwischen Gleichspannungsquelle (01) und Umrichter (12) eingekoppelt wird.

27. Verwendung nach einem der Ansprüche 21 bis 25,
**dadurch gekennzeichnet,**
**dass** die Gesamtmessspannung $U_{mess}$ über mindestens zwei Ankoppelwiderstände (02) in mindestens zwei Phasen eines dreiphasigen Motorstromkreises eingekoppelt wird.

28. Verwendung nach einem der Ansprüche 21 bis 24,
**dadurch gekennzeichnet,**
**dass** die Gesamtmessspannung $U_{mess}$ über mindestens zwei Ankoppelwiderstände (02) eingekoppelt wird, wobei ein erster Ankoppelwiderstand (02) in den Gleichstromkreis und ein zweiter Ankoppelwiderstand (02) in den Motorstromkreis einkoppelt wird, wobei zumindest der Isolationszustand beider Stromkreise bestimmbar ist, wenn kein Energietransfer durch den Umrichter (12) erfolgt.

29. Vorrichtung zur Durchführung eines Verfahrens nach einem der vorgenannten Ansprüche, umfassend
eine einseitig mit einer Masse (16) verbundene Impulsmessspannungsquelle (04) zur Generierung einer Gesamtmessspannung $U_{mess}$; mindestens ein Ankoppelnetzwerk (02, 03) umfassend mindestens einen Ankoppelwiderstand (02) und einen Messwiderstand (03) zum einkoppeln der Gesamtmessspannung $U_{mess}$ in das Spannungsnetz; und eine Isolationsmesseinrichtung (18) zur Bestimmung der Ableitimpedanz und des Isolationswiderstands
**dadurch gekennzeichnet,**
**dass** die Impulsmessspannungsquelle (04) ausgelegt ist, eine Gesamtmessspannung $U_{mess}$ zu generieren, die sich aus einer Überlagerung einer Messgleichspannung $U_{mess=}$ mit einer vorbestimmbaren Messzeitspanne $t_{var}$ und mindestens einer Messwechselspannung $U_{mess\sim}$ mit einer Messperiodendauer $t_{cons}$ ergibt; und die Isolationsmesseinrichtung (18) ausgelegt ist, auf Basis der generierten Gesamtmessspanung $U_{mess}$ einen durch die Gesamtmessspannung $U_{mess}$ erzeugten Gesamtstrom $I_{mess}$ zu messen, und in einen Messgleichstrom $I_{mess=}$ und einen Messwechselstrom $I_{mess\sim}$ zu zerlegen, um auf Basis der Messgleichspannung $U_{mess=}$ und des Messgleichstroms $I_{mess=}$ einen Isolationswiderstand R= und auf Basis der Messwechselspannung $U_{mess\sim}$ und des Messwechselstroms $I_{mess\sim}$ eine Isolationsimpedanz $Z_\sim$ zu bestimmen.

30. Vorrichtung nach Anspruch 29,
**dadurch gekennzeichnet,**
**dass** die Isolationsmesseinrichtung (18) Filterelemente umfasst, die ausgelegt sind, einen am Messwiderstand (03) gemessenen Gesamtmessstrom $I_{mess}$ in einen Messgleichstrom $I_{mess=}$ und in einen Messwechselstrom $I_{mess\sim}$ aufzuspalten.

31. Vorrichtung nach Anspruch 30,
**dadurch gekennzeichnet,**
**dass** die Filterelemente mindestens einen Tiefpass (06) für die Ermittlung des Isolationswiderstands $R_=$ und einen Bandpass (07) für die Ermittlung der Isolationsimpedanz $Z_\sim$ umfasst.

32. Vorrichtung nach Anspruch 29 oder 30,
**dadurch gekennzeichnet,**
**dass** die Filterelemente einen vorgeschalteten Tiefpass (05) zur Ausfilterung von Störsignalen umfasst.

**33.** Vorrichtung nach einem der Ansprüche 29 bis 32, **dadurch gekennzeichnet, dass** zumindest Teile der Filterelemente (05, 06, 07) als im Betrieb elektronisch einstellbare Filterelemente ausgelegt sind, so dass Frequenzparameter wie Grenz-, Mitten- und Bandbreitenfrequenzen einstellbar sind.

**34.** Vorrichtung nach einem der vorgenannten Vorrichtungsansprüche, **dadurch gekennzeichnet, dass** die Isolationsmesseinrichtung (18) mindestens einen A/D-Wandler umfasst, um die am Messwiderstand (03) gemessenen Strom- und/oder Spannungswerte digital zu wandeln.

**35.** Vorrichtung nach Anspruch 34, **dadurch gekennzeichnet, dass** die Isolationsmesseinrichtung (18) mindestens eine FFT/DFT-Verarbeitungseinrichtung umfasst, um zumindest die Messwerte zur Ermittlung der Ableitimpedanz $Z_{\sim}$ in den Frequenzbereich zu transformieren.

**36.** Vorrichtung nach einem der vorgenannten Vorrichtungsansprüche, **dadurch gekennzeichnet, dass** die Isolationsmesseinrichtung (18) einen Mikrocontroller (10) umfasst, der ausgelegt ist, eine Signalverarbeitung der gemessenen Spannungs-/Stromwerte vorzunehmen, und den ermittelten Isolationswiderstand $R_{=}$ und die ermittelte Isolationsimpedanz $Z_{\sim}$ bzw. Isolationswiderstand $R_{\sim}$ und Ableitkapazität $C_{\sim}$ zu bestimmen.

**37.** Vorrichtung nach einem der vorgenannten Vorrichtungsansprüche, **dadurch gekennzeichnet, dass** die Isolationsmesseinrichtung (18) ein I/O-Interface umfasst, wobei mittels eines Optokopplers (11) PWM-modulierte Daten der Isolationsmesseinrichtung (18) ausgegeben werden können.

**38.** Vorrichtung nach einem der vorgenannten Vorrichtungsansprüche, **dadurch gekennzeichnet, dass** die Isolationsmesseinrichtung (18) ein I/O-Interface umfasst, wobei das I/O Interface digitale Daten an eine CAN- oder LIN-Schnittstelle übertragen kann.

**Claims**

**1.** A method for monitoring the insulation of an unearthed DC and/or AC voltage network, comprising the steps:

- generation of a DC measurement voltage $U_{\text{mess}=}$ connected to earth (16) on one side for a predeterminable measurement period $t_{\text{var}}$;
- generation and superposition of at least one AC measurement voltage $U_{\text{mess}\sim}$ connected to earth (16) with a periodic time $t_{\text{cons}}$ onto the DC measurement voltage $U_{\text{mess}=}$ for the purpose of forming a total measurement voltage $U_{\text{mess}}$;
- introduction of the total measurement voltage $U_{\text{mess}}$ into the voltage network to be monitored and measurement of a total measurement current $I_{\text{mess}}$ generated by the total measurement voltage $U_{\text{mess}}$, said total measurement current $I_{\text{mess}}$ being divided into a DC measurement current $I_{\text{mess}=}$ and an AC measurement current $I_{\text{mess}\sim}$;
- determination of an insulation resistance $R_{=}$ on the basis of the DC measurement voltage $U_{\text{mess}=}$ and of the DC measurement current $I_{\text{mess}=}$ as well as determination of an insulation impedance $Z_{\sim}$ on the basis of the AC measurement voltage $U_{\text{mess}\sim}$ and of the AC measurement current $I_{\text{mess}\sim}$.

**2.** The method in accordance with claim 1, **characterised in that** an insulation resistance $R_{\sim}$ and a leakage capacitance $C_{\sim}$ are determined from the insulation impedance $Z_{\sim}$.

**3.** The method in accordance with claim 2, **characterised in that** in the case of a voltage network-specific small leakage capacitance $C_{\sim}$, the insulation resistance $R_{\sim}$ is output as an insulation resistance of the voltage network, and in the case of a large leakage capacitance $C_{\sim}$, the insulation resistance $R_{=}$ is output as an insulation resistance of the voltage network.

**4.** The method in accordance with claim 2 or 3, **characterised in that** in the case of a difference between the insulation resistances $R_{\sim}$ and $R_{=}$ that exceeds tolerances, the method is repeated with variation of the DC voltage measurement period $t_{\text{var}}$ and/or of the periodic time $t_{\text{cons}}$ until $R_{\sim}$ and $R_{\sim}$ have come closer together, at least within a predeterminable tolerance range.

**5.** The method in accordance with one of the preceding claims, **characterised in that** the measurement of the total measurement current $I_{\text{mess}}$ or of the measurement current components $I_{\text{mess}\sim}$ / $I_{\text{mess}=}$ comprises a digitalisation of the measurement values.

**6.** The method in accordance with one of the preceding claims,

**characterised in that**
the division of the total measurement current $I_{mess}$ into the DC measurement current $I_{mess=}$ comprises at least one low-pass filtering of the total measurement current $I_{mess}$ by means of a low-pass filter (05, 06).

7. The method in accordance with one of the preceding claims,
**characterised in that**
the division of the total measurement current $I_{mess}$ into the AC measurement current $I_{mess\sim}$ comprises a band-pass filtering of the total measurement current $I_{mess}$ by means of a band-pass filter (07).

8. The method in accordance with claim 6 or 7,
**characterised in that**
the bandwidth and the central frequency of the band-pass filter (07) and/or the cut-off frequency of the low-pass filter (05, 06) can be adjusted electronically.

9. The method in accordance with one of the preceding claims,
**characterised in that**
the method for monitoring the insulation is executed cyclically, in particular continuously, with adjustable time intervals between the measurements.

10. The method in accordance with claim 9,
**characterised in that**
the determination of the insulation resistance $R_{=}$ comprises a statistical evaluation of the measurement values $R_{=}$, $I_{mess=}$ and/or $U_{mess=}$ over a plurality of measurement cycles executed one after another with measurement periods $t_{var}$, in particular a continuous formation of an average value.

11. The method in accordance with claim 9 or 10,
**characterised in that**
the measurement period $t_{var}$ is variably adjustable for each measurement cycle, in order to combat the leakage capacitance and disturbances of the voltage network.

12. The method in accordance with one of the preceding claims,
**characterised in that**
a measurement period $t_{var}$ is determined from a derived insulation impedance $Z_{\sim}$, in accordance with the equation $t_{var}=n*R_i*C_{\sim}$, where $R_i$ is the internal resistance of the insulation measurement unit, and **in that** $n \geq 3$ is determined.

13. The method in accordance with one of the preceding claims,
**characterised in that**
the measurement period $t_{var}$ is at least one second.

14. The method in accordance with one of the preceding claims,
**characterised in that**
the measurement period $t_{var}$ is between one and five seconds in length.

15. The method in accordance with one of the preceding claims,
**characterised in that**
the measurement period $t_{var}$ is a whole number multiple of the periodic time $t_{cons}$.

16. The method in accordance with claim 15,
**characterised in that**
the periodic time $t_{cons}$ is approximately $t_{var}/10$.

17. The method in accordance with one of the preceding claims,
**characterised in that**
the periodic time $t_{cons}$ is approximately 0.1 seconds.

18. The method in accordance with one of the preceding claims,
**characterised in that**
the periodic time is $t_{cons} < 2\pi C_{\sim} R_a$, $R_a$ being the response value of an insulation measurement unit (18), which measures the insulation values.

19. The method in accordance with claim 5,
**characterised in that**
the determination of the insulation impedance $Z_{\sim}$ comprises a discrete Fourier transformation (DFT/FFT), at least the determination of the insulation impedance $Z_{\sim}$, the leakage capacitance $C_{\sim}$ and the insulation resistance $R_{\sim}$ being undertaken in the frequency domain.

20. The method in accordance with one of the preceding claims,
**characterised in that**
the leakage capacitance $C_{\sim}$ is determined by means of the measured insulation impedance $Z_{\sim}$ and of the insulation resistance $R_{=}$ in accordance with

$$C_{\sim} = \frac{1}{\omega} \sqrt{\frac{1}{Z_{\sim}^2} - \frac{1}{R_{=}^2}} \ .$$

21. An application of a method in accordance with one of the preceding claims in a voltage network with a dynamically alterable voltage,
**characterised in that**
the method is deployed for monitoring the insulation in a converter circuit for the dynamic operation of a single-phase or three-phase AC motor (15), a DC circuit being coupled with a motor circuit via a converter (12).

22. The application in accordance with claim 21, **characterised in that** the method is applied in a vehicle with an electric motor drive, in particular in a hybrid vehicle, for the purpose of monitoring the insulation.

23. The application in accordance with claim 22, **characterised in that** the electric motor can also operate as a generator, and **in that** a transfer of energy can take place from the motor side to the DC side, wherein the method can monitor the insulation when the motor is operating in either motor mode or generator mode.

24. The application in accordance with one of the claims 21 to 23, **characterised in that** the insulation resistance or the leakage impedance of the DC voltage circuit (08, 09) and/or of the single-phase or three-phase AC motor circuit (13, 14) is respectively monitored.

25. The application in accordance with one of the claims 21 to 24, **characterised in that** in the case of simultaneous monitoring of the insulation resistances/impedance (08, 09, 13, 14) in the DC and motor circuits, the periodic time $t_{cons}$ of the respective AC measurement voltages $U_{mess\sim}$ is selected such that the measurement signals do not interfere with one another.

26. The application in accordance with one of the claims 21 to 25, **characterised in that** the total measurement voltage $U_{mess}$ is coupled, via two coupling resistances (02), into the two DC voltage paths between the DC voltage source (01) and the converter (12).

27. The application in accordance with one of the claims 21 to 25, **characterised in that** the total measurement voltage $U_{mess}$ is coupled, via at least two coupling resistances (02), into at least two phases of a three-phase motor circuit.

28. The application in accordance with one of the claims 21 to 24, **characterised in that** the total measurement voltage $U_{mess}$ is coupled in via at least two coupling resistances (02), a first coupling resistance (02) being coupled into the DC circuit and a second coupling resistance (02) being coupled into the motor circuit, wherein at least the insulation resistance of both circuits can be determined if no energy transfer is taking place through the converter (12).

29. A device for the execution of a method in accordance with one of the above-cited claims, comprising an impulse measurement voltage source (04), connected to earth (16) on one side, for the purpose of generating a total measurement voltage $U_{mess}$; at least one coupling network (02, 03), comprising at least one coupling resistance (02) and one measuring resistance (03) for the purpose of coupling the total measurement voltage $U_{mess}$ into the voltage network; and an insulation measurement unit (18) for the purpose of determining the leakage impedance and the insulation resistance, **characterised in that** the impulse measurement voltage source (04) is designed to generate a total measurement voltage $U_{mess}$, which ensues from a superposition of a DC measurement voltage $U_{mess=}$ with a predeterminable measurement period $t_{var}$ and at least one AC measurement voltage $U_{mess\sim}$ with a periodic time $t_{cons}$; and **in that** the insulation measurement unit (18) is designed to measure, on the basis of the generated total measurement voltage $U_{mess}$, a total current $I_{mess}$ that is generated by the total measurement voltage $U_{mess}$, and to divide said total current $I_{mess}$ into a DC measurement current $I_{mess=}$ and an AC measurement current $I_{mess\sim}$ in order to determine an insulation resistance $R_=$ on the basis of the DC measurement voltage $U_{mess=}$ and of the DC measurement current $I_{mess=}$ and an insulation impedance $Z_\sim$ on the basis of the AC measurement voltage $U_{mess\sim}$ and of the AC measurement current $I_{mess\sim}$.

30. The device in accordance with claim 29, **characterised in that** the insulation measurement unit (18) comprises filter elements that are designed to divide a total measurement current $I_{mess}$ measured at the measuring resistance (03) into a DC measurement current $I_{mess=}$ and into an AC measurement current $I_{mess\sim}$.

31. The device in accordance with claim 30, **characterised in that** the filter elements comprise at least one low-pass filter (06) for the derivation of the insulation resistance $R_=$ and one band-pass filter (07) for the derivation of the insulation impedance $Z_\sim$.

32. The device in accordance with claim 29 or 30, **characterised in that** the filter elements comprise one upstream low-pass filter (05) for the purpose of filtering out interference signals.

33. The device in accordance with one of the claims 29 to 32,
**characterised in that**
at least parts of the filter elements (05, 06, 07) are designed as filter elements that can be electronically adjusted under operational conditions so that frequency parameters such as cut-off, central and bandwidth frequencies can be adjusted.

34. The device in accordance with one of the above-cited device claims,
**characterised in that**
the insulation measurement unit (18) comprises at least one A/D-converter in order to convert the current and/or voltage values measured at the measuring resistance (03) to digital forms.

35. The device in accordance with claim 34,
**characterised in that**
the insulation measurement unit (18) comprises at least one FFT/DFT processing unit in order to transform at least the values measured for the derivation of the leakage impedance $Z_\sim$ into the frequency domain.

36. The device in accordance with one of the above-cited device claims,
**characterised in that**
the insulation measurement unit (18) comprises a microcontroller (10) that is designed to undertake signal processing of the measured voltage/current values and to determine the derived insulation resistance $R_=$ and the derived insulation impedance $Z_\sim$, and the insulation resistance $R_\sim$ and the leakage capacitance $C_\sim$ respectively.

37. The device in accordance with one of the above-cited device claims,
**characterised in that**
the insulation measurement unit (18) comprises an I/O interface, wherein by means of an optical coupler (11), PWM-modulated data of the insulation measurement unit (18) can be output.

38. The device in accordance with one of the above-cited device claims,
**characterised in that**
the insulation measurement unit (18) comprises an I/O interface, wherein the I/O interface can transfer digital data to a CAN or LIN interface.

**Revendications**

1. Procédé de surveillance de l'isolation d'un réseau à tension continue et/ou alternative non mis à la terre, comprenant les étapes consistant à:

- génération d'une tension continue de mesure $U_{\text{mess}=}$ qui est reliée à une masse (16) d'un côté pour une période de mesure $t_{\text{var}}$ prédéterminable;
- génération et superposition d'au moins une tension alternative de mesure $U_{\text{mess}\sim}$ qui est reliée à une masse (16) ayant une durée de période de mesure $t_{\text{cons}}$ sur la tension continue de mesure $U_{\text{mess}=}$ pour former une tension de mesure totale $U_{\text{mess}}$;
- alimentation de la tension de mesure totale $U_{mess}$ dans le réseau à tension à être surveillé et mesure d'un courant de mesure total $I_{\text{mess}}$ qui est généré par la tension de mesure totale $U_{\text{mess}}$, ledit courant de mesure total $I_{\text{mess}}$ étant divisé en un courant continu de mesure $I_{\text{mess}=}$ et en un courant alternatif de mesure $I_{\text{mess}\sim}$;
- détermination d'une résistance d'isolement $R_=$ sur la base de la tension continue de mesure $U_{\text{mess}=}$ et du courant continu de mesure $I_{\text{mess}=}$, ainsi que détermination de l'impédance d'isolement $Z_\sim$ sur la base de la tension alternative de mesure $U_{\text{mess}\sim}$ et du courant alternatif de mesure $I_{\text{mess}\sim}$.

2. Procédé selon la revendication 1,
**caractérisé en ce qu'**
une résistance d'isolement $R_\sim$ et une capacité de fuite $C_\sim$ sont déterminées à partir de l'impédance d'isolement $Z_\sim$.

3. Procédé selon la revendication 2,
**caractérisé en ce qu'**
en cas de capacité de fuite $C_\sim$ basse spécifique au réseau à tension, la résistance d'isolement $R_\sim$ est issu comme la résistance d'isolement du réseau à tension, et **en ce qu'**en cas de capacité de fuite $C_\sim$ élevée, la résistance d'isolement $R_=$ est issu comme la résistance d'isolement du réseau à tension.

4. Procédé selon la revendication 2 ou 3,
**caractérisé en ce qu'**
en cas de différence entre les résistances d'isolement $R_\sim$ et $R_\sim$ qui dépasse la tolérance, le procédé est répété en changeant la période de mesure de la tension continue $t_{\text{var}}$ et/ou la durée de période de mesure $t_{\text{cons}}$ jusqu'à ce que $R_\sim$ et $R_\sim$ sont approchées au moins dans une plage de tolérance prédéterminable.

5. Procédé selon l'une quelconque des revendications précédentes,
**caractérisé en ce que**
la mesure du courant de mesure total $I_{\text{mess}}$ ou des courants de mesure partiels $I_{\text{mess}\sim}$/$I_{\text{mess}=}$ comprend une numérisation des valeurs mesurées.

6. Procédé selon l'une quelconque des revendications précédentes,

**caractérisé en ce que**

la division du courant de mesure total $I_{mess}$ dans le courant continu de mesure $I_{mess=}$ comprend au moins un filtrage passe-bas du courant de mesure total $I_{mess}$ moyennant un filtre passe-bas (05, 06).

7. Procédé selon l'une quelconque des revendications précédentes,
   **caractérisé en ce que**
   la division du courant de mesure total $I_{mess}$ dans le courant alternatif de mesure $I_{mess\sim}$ comprend un filtrage passe-bande du courant de mesure total $I_{mess}$ moyennant un filtre passe-bande (07).

8. Procédé selon la revendication 6 ou 7,
   **caractérisé en ce que**
   la largeur de bande et la fréquence centrale de la bande du filtre passe-bande (07) et/ou la fréquence de coupure du filtre passe-bas (05, 06) peut être réglée électroniquement.

9. Procédé selon l'une quelconque des revendications précédentes,
   **caractérisé en ce que**
   le procédé de surveillance de l'isolation est exécuté cycliquement, en particulier continûment, avec des intervalles de temps de mesure réglables.

10. Procédé selon la revendication 9,
    **caractérisé en ce que**
    la détermination de la résistance d'isolement $R_=$ comprend une évaluation statistique des valeurs mesurées $R_=$, $I_{mess=}$ et/ou $U_{mess=}$ de plusieurs cycles de mesure qui sont exécutés l'un après l'autre, ayant des périodes de mesure $t_{var}$, en particulier comprend une formation glissante d'une valeur moyenne.

11. Procédé selon la revendication 9 ou 10,
    **caractérisé en ce que**
    la période de mesure $t_{var}$ peut être réglée de façon variable pour chaque cycle de mesure afin de contrer la capacité de fuite et des perturbations du réseau à tension.

12. Procédé selon l'une quelconque des revendications précédentes,
    **caractérisé en ce qu'**
    une période de mesure $t_{var}$ est déterminée à partir de l'impédance d'isolement déterminée $Z_\sim$ selon la formule $t_{var}=n*R_i*C_\sim$, dans lequel $R_i$ est la résistance interne du dispositif de mesure de l'isolation, et **en ce que** $n\geq3$ est déterminé.

13. Procédé selon l'une quelconque des revendications précédentes,
    **caractérisé en ce que**
    la période de mesure $t_{var}$ est d'au moins une seconde.

14. Procédé selon l'une quelconque des revendications précédentes,
    **caractérisé en ce que**
    la période de mesure $t_{var}$ présente une longueur entre une et cinq secondes.

15. Procédé selon l'une quelconque des revendications précédentes,
    **caractérisé en ce que**
    la période de mesure $t_{var}$ est un multiple en nombres entiers de la durée de période de mesure $t_{cons}$.

16. Procédé selon la revendication 15,
    **caractérisé en ce que**
    la durée de période de mesure $t_{cons}$ est d'à peu près $t_{var}/10$.

17. Procédé selon l'une quelconque des revendications précédentes,
    **caractérisé en ce que**
    la durée de période de mesure $t_{cons}$ est d'à peu près 0.1 sec.

18. Procédé selon l'une quelconque des revendications précédentes,
    **caractérisé en ce que**
    la durée de période de mesure est $t_{cons} < 2\pi C_\sim R_a$, $R_a$ étant la valeur de fonctionnement d'un dispositif de mesure de l'isolation (18) qui mesure les valeurs d'isolation.

19. Procédé selon la revendication 5,
    **caractérisé en ce que**
    la détermination de l'impédance d'isolement $Z_\sim$ comprend une transformation de Fourier discrète (DFT/FFT), au moins la détermination de l'impédance d'isolement $Z_\sim$, de la capacité de fuite $C_\sim$ et de la résistance d'isolement $R_\sim$ étant effectuée dans la gamme de fréquences.

20. Procédé selon l'une quelconque des revendications précédentes,
    **caractérisé en ce que**
    la capacité de fuite $C_\sim$ est déterminée moyennant l'impédance d'isolement $Z_\sim$ mesurée et la résistance d'isolement $R_\sim$ selon $C_\sim = \dfrac{1}{\omega}\sqrt{\dfrac{1}{Z_\sim^2}-\dfrac{1}{R_=^2}}$.

21. Utilisation d'un procédé selon l'une quelconque des revendications précédentes dans un réseau à tension avec une tension qui est modifiable de façon dynamique,
    **caractérisé en ce que**

le procédé de surveillance de l'isolation est employé dans un circuit de convertisseur pour l'opération dynamique d'un moteur à courant alternatif ou à courant alternatif triphasé (15), un circuit à courant continu étant accouplé à un circuit moteur au travers d'un convertisseur (12).

**22.** Utilisation selon la revendication 21,
**caractérisé en ce que**
le procédé est utilisé dans un véhicule ayant un entraînement par moteur électrique, en particulier dans un véhicule automobile hybride, pour la surveillance de l'isolation.

**23.** Utilisation selon la revendication 22,
**caractérisé en ce que**
le moteur électrique peut aussi fonctionner comme un générateur et **en ce qu'**un transfert d'énergie peut se dérouler à partir du côté moteur vers le côté du courant continu, le procédé pouvant surveiller l'isolation non seulement dans l'opération motrice, mais aussi dans l'opération en mode générateur.

**24.** Utilisation selon l'une quelconque des revendications 21 à 23,
**caractérisé en ce que**
la résistance d'isolement ou l'impédance de fuite du circuit à tension continue (08, 09) et/ou du circuit moteur à courant alternatif ou à courant alternatif triphasé (13, 14) est respectivement surveillé.

**25.** Utilisation selon l'une quelconque des revendications 21 à 24,
**caractérisé en ce que**
lors de la surveillance simultanée des résistances d'isolement/impédances (08, 09, 13, 14) dans le circuit à courant continu et le circuit moteur, les durées de période de mesure $t_{cons}$ des tensions alternatives de mesure $U_{mess\sim}$ respectives sont choisies de telle façon que les signaux de mesure ne se perturbent pas mutuellement.

**26.** Utilisation selon l'une quelconque des revendications 21 à 25,
**caractérisé en ce que**
la tension de mesure totale $U_{mess}$ est intégrée, au travers de deux résistances d'accouplement (02), dans les deux circuits à tension continue entre la source de tension continue (01) et le convertisseur (12).

**27.** Utilisation selon l'une quelconque des revendications 21 à 25,
**caractérisé en ce que**
la tension de mesure totale $U_{mess}$ est intégrée, au travers de d'au moins deux résistances d'accouplement (02), dans au moins deux phases d'un circuit moteur triphasé.

**28.** Utilisation selon l'une quelconque des revendications 21 à 24,
**caractérisé en ce que**
la tension de mesure totale $U_{mess}$ est intégrée au travers d'au moins deux résistances d'accouplement (02), une première résistance d'accouplement (02) étant intégrée dans le circuit à courant continu et une deuxième résistance d'accouplement (02) étant intégrée dans le circuit moteur, au moins la résistance d'isolement des deux circuits étant déterminable si aucun transfert d'énergie est effectué par le convertisseur (12).

**29.** Dispositif pour exécuter un procédé selon l'une quelconque des revendications mentionnées ci-dessus, comprenant
une source de tension de mesure d'impulsion (04) qui est reliée à une masse (16) d'un côté, pour générer une tension de mesure totale $U_{mess}$;
au moins un réseau d'accouplement (02, 03) comprenant au moins une résistance d'accouplement (02) et une résistance de mesure (03) pour intégrer la tension de mesure totale $U_{mess}$ dans le réseau à tension;
et un unité de mesure de l'isolation (18) pour déterminer l'impédance de fuite et la résistance d'isolement
**caractérisé en ce que**
la source de tension de mesure d'impulsion (04) est conçu pour générer une tension de mesure totale $U_{mess}$ qui résulte d'une superposition d'une tension continue de mesure $U_{mess}=$ ayant une période de mesure prédéterminable $t_{var}$ et d'au moins une tension alternative de mesure $U_{mess\sim}$ ayant une durée de période de mesure $t_{cons}$;
et **en ce que** l'unité de mesure de l'isolation (18) est conçu pour mesurer, sur la base de la tension de mesure totale $U_{mess}$ générée, un courant total $I_{mess}$ qui est généré par la tension de mesure totale Umess et pour diviser ledit courant total $I_{mess}$ en un courant continu de mesure $I_{mess}=$ et un courant alternatif de mesure $I_{mess}\sim$ afin de déterminer, sur la base de la tension continue de mesure $U_{mess}=$ et du courant continu de mesure $I_{mess}=$, une résistance d'isolement $R=$, et, sur la base de la tension alternative de mesure $U_{mess\sim}$ et du courant alternatif de mesure $I_{mess}\sim$, une impédance d'isolement $Z\sim$.

**30.** Dispositif selon la revendication 29,
**caractérisé en ce que**
l'unité de mesure de l'isolation (18) comprend des éléments de filtrage qui sont conçu pour diviser un courant de mesure total $I_{mess}$ mesuré sur la résistance de mesure (03) en un courant continu de mesure $I_{mess}=$ et un courant alternatif de mesure $I_{mess\sim}$.

**31.** Dispositif selon la revendication 30,
**caractérisé en ce que**

les éléments de filtrage comprennent au moins un filtre passe-bas (06) pour calculer la résistance d'isolement $R$ = et un filtre passe-bande (07) pour calculer l'impédance d'isolement $Z\sim$.

**32.** Dispositif selon la revendication 29 ou 30, **caractérisé en ce que** les éléments de filtrage comprennent un filtre passe-bas (05) disposé en amont pour extraire des signaux de non désirés par filtration.

**33.** Dispositif selon l'une quelconque des revendications 29 à 32, **caractérisé en ce qu'** au moins parties des éléments de filtrage (05, 06, 07) sont conçus comme des éléments de filtrage qui peuvent être réglés électroniquement en service, de telle façon que des paramètres de fréquence comme les fréquences de coupure, les fréquences centrales et les fréquences de de la largeur de bande peuvent être réglés.

**34.** Dispositif selon l'une quelconque des revendications de dispositif mentionnées ci-dessus, **caractérisé en ce que** l'unité de mesure de l'isolation (18) comprend au moins un convertisseur analogique-numérique afin de numériser les valeurs de courant et/ou de tension mesurées sur la résistance de mesure (03).

**35.** Dispositif selon la revendication 34, **caractérisé en ce que** l'unité de mesure de l'isolation (18) comprend au moins une unité de traitement FFT/DFT afin de transformer au moins les valeurs mesurées pour calculer l'impédance de fuite $Z\sim$ in dans la gamme de fréquences.

**36.** Dispositif selon l'une quelconque des revendications de dispositif mentionnées ci-dessus, **caractérisé en ce que** l'unité de mesure de l'isolation (18) comprend un microcontrôleur (10) qui est conçu pour procéder à un traitement des signaux des valeurs de tension/courant mesurées et pour déterminer la résistance d'isolement $R$ = déterminée et l'impédance d'isolement $Z\sim$ déterminée, ou bien la résistance d'isolement $R\sim$ et l'impédance de fuite $C\sim$.

**37.** Dispositif selon l'une quelconque des revendications de dispositif mentionnées ci-dessus, **caractérisé en ce que** l'unité de mesure de l'isolation (18) comprend une interface entrée/sortie, des données de l'unité de mesure de l'isolation (18) après modulation de la largeur des impulsions électriques pouvant être issues moyennant un optocoupleur (11).

**38.** Dispositif selon l'une quelconque des revendications de dispositif mentionnées ci-dessus, **caractérisé en ce que** l'unité de mesure de l'isolation (18) comprend une interface entrée/sortie, l'interface entrée/sortie pouvant transmettre des données numériques à une interface CAN ou LIN.

Fig. 1

Fig. 2

Fig. 3

Fig. 4

Start

Digitalisierung
Messwert
Bandpass

Digitalisierung
Messwert
Tiefpass

Diskrete Fourier-
Transformation

Statistische
Auswertung
10 Messwerte

Berechung Impedanz,
Ableitkapazität,
Isolationswiderstand 1

Berechung
Isolationswiderstand 2

kleine
Ableitkapazität

Ja

Nein

Ausgabe
Isolationswiderstand 1
/ Impedanz

Ausgabe
Isolationswiderstand 2

Fig. 5

Fig. 6

Fig. 7

Gleichstromkreis

Motorstromkreis

EP 2 256 506 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0654673 B1
- EP 1586910 B1
- DE 10106200 C1
- US 5450328 A
- EP 0593007 A2
- EP 0654673 A1